# EUROPEAN PATENT APPLICATION

(11) **EP 4 739 053 A1**
(43) Date of publication of application: **06.05.2026**
(21) Application number: 25212806.1
(22) Date of filing: 31.10.2025
(51) Int. Cl.: H10K 59/122, H10K 59/80, H10K 59/131

(54) **DISPLAY PANEL AND ELECTRONIC DEVICE INCLUDING THE SAME**

(30) Priority: 01.11.2024 KR 20240153651; 19.02.2025 KR 20250021380
(71) Applicant: Samsung Display Co., Ltd., Yongin-si, Gyeonggi-do 17113 (KR)
(72) Inventor: KANG, Ki Nyeng, 17113 Yongin-si (KR); LEE, Sungeun, 17113 Yongin-si (KR); PARK, Jimin, 17113 Yongin-si (KR); KWON, Dohyun, 17113 Yongin-si (KR); KIM, Daeyong, 17113 Yongin-si (KR); KIM, Sikwang, 17113 Yongin-si (KR); KIM, Hyoeng-Ki, 17113 Yongin-si (KR); NAM, Yunyong, 17113 Yongin-si (KR); MOON, Junhwan, 17113 Yongin-si (KR); PARK, Jonghee, 17113 Yongin-si (KR); PARK, Chanju, 17113 Yongin-si (KR); BAEK, Jongjun, 17113 Yongin-si (KR); SONG, Keunkyu, 17113 Yongin-si (KR); LEE, Jaehun, 17113 Yongin-si (KR)
(74) Representative: Taor, Simon Edward William

(57) **Abstract**

An electronic device includes a pixel definition layer through which first openings at least partially overlapping light emitting areas and second openings overlapping a contact area are defined, a light emitting element including a first electrode of which at least a portion is exposed through the first opening, a second electrode, and a common layer, a border barrier wall overlapping the contact area and disposed on the pixel definition layer. At least a portion of the first electrode overlapping a non-display area is exposed through the second openings, and the second electrode at least partially covers the border barrier wall in the non-display area and is connected to the first electrode exposed through the second openings.

## Description

### CROSS-REFERENCE TO RELATED APPLICATION(S)

This application is based on and claims priority to Korean Patent Application Nos. 10-2024-0153651, filed on November 1, 2024, and 10-2025-0021380, filed on February 19, 2025, in the Korean Intellectual Property Office.

### BACKGROUND

The present disclosure relates to a display panel and an electronic device including the same. More particularly, the present disclosure relates to an electronic device including a display panel having an improved display quality and a simplified method of manufacturing the same.

Multimedia electronic apparatuses, such as smartphones, digital cameras, laptop computers, navigation units, and smart televisions, which generate images, include an electronic device to display the images through a display screen.

This electronic device includes multiple pixels to generate images and multiple lines connected to the pixels. The pixels receive driving signals through the lines to be driven by the driving signals.

In medium-sized to large-sized electronic devices with large display areas, such as tablet computers or smart televisions, differences occur in driving voltages applied to each pixel, and thus, a design that compensates for these differences is required.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

The present disclosure provides an electronic device including a display panel capable of applying a constant driving voltage to pixels.

Embodiments of the disclosure provide an electronic device which may include: a processor configured to provide image data; a display panel connected to the processor; and a driver configured to receive the image data and drive the display panel based on the image data. The display panel may include: a base substrate comprising a display area comprising a light emitting area and a non-light-emitting area and a non-display area adjacent to the display area and comprising a contact area; a pixel definition layer through which a first opening overlapping the light emitting area and a second opening at least partially overlapping the contact area in a third direction perpendicular to a first direction and a second direction in parallel with a top surface of the base substrate are defined, the pixel definition layer being on the base substrate; a light emitting element comprising a first electrode of which at least a portion is exposed through the first opening, a second electrode on the first electrode, and a common layer between the first electrode and the second electrode; a border barrier wall on the pixel definition layer, the border barrier wall overlapping the contact area in the third direction, wherein at least a portion of the first electrode overlapping the non-display area is exposed through the second opening, and the second electrode covers the border barrier wall in the non-display area and is connected to the first electrode exposed through the second opening.

The border barrier wall may include: a first pattern on the pixel definition layer, a second pattern on the first pattern, a first barrier wall pattern on the second pattern, and a second barrier wall pattern on the first barrier wall pattern.

The first barrier wall pattern may include aluminum, and the second barrier wall pattern may include titanium.

The first barrier wall pattern may have a width smaller than a width of the second barrier wall pattern, and the first barrier wall pattern may have a thickness greater than a thickness of the second barrier wall pattern.

The second pattern may have a width greater than a width of the second barrier wall pattern.

The second pattern may have a width greater than a width of the first pattern.

The electronic device may include a dummy pattern on the second barrier wall pattern and at least partially covered by the second electrode, and the dummy pattern may include the same material as a common layer.

The electronic device may include a protective layer disposed between the dummy pattern and the second barrier wall pattern and including an inorganic material.

The second barrier wall pattern that protrudes from the first barrier wall pattern may define a tip portion protruded downward.

The electronic device further may include a normal barrier wall overlapping the non-light-emitting area and disposed on the pixel definition layer, and the normal barrier wall may be covered by the second electrode.

The normal barrier wall may have the same shape as the border barrier wall.

The normal barrier wall may be provided integrally with the border barrier wall as a pattern.

The second electrode may have a thickness greater than a thickness of the first pattern.

The second openings may be arranged in a first direction and a second direction intersecting the first direction in the contact area, and the border barrier wall may not overlap the second openings in the contact area.

The border barrier wall may include first portions extending in the first direction and spaced apart from each other in the second direction and second portions disposed between the first portions adjacent to each other.

Each of the second portions may have a stepped shape.

Each of the second portions may extend in the second direction.

The electronic device further may include a thin film encapsulation layer including a first inorganic layer covering the light emitting element, a second inorganic layer on the first inorganic layer, and an organic layer between the first inorganic layer and the second inorganic layer.

The display panel further may include a dam portion disposed in the non-display area and surrounding at least a portion of the contact area, and the dam portion includes organic patterns sequentially stacked.

A boundary of the organic layer is defined by the dam portion in the non-display area.

Embodiments of the disclosure provide a display panel which may include: a base substrate comprising a display area comprising a light emitting area and a non-light-emitting area and a non-display area adjacent to the display area and comprising a contact area; a pixel definition layer through which a first opening overlapping the light emitting area and a second opening at least partially overlapping the contact area in a third direction perpendicular to a first direction and a second direction in parallel with a top surface of the base substrate are defined, the pixel definition layer being on the base substrate; a light emitting element comprising a first electrode of which at least a portion is exposed through the first opening, a second electrode on the first electrode, and a common layer between the first electrode and the second electrode; a border barrier wall on the pixel definition layer, the border barrier wall overlapping the contact area in the third direction, wherein at least a portion of the first electrode overlapping the non-display area is exposed through the second opening, and the second electrode covers the border barrier wall in the non-display area and is connected to the first electrode exposed through the second opening.

The border barrier wall may include: a first pattern on the pixel definition layer, a second pattern on the first pattern, a first barrier wall pattern on the second pattern, and a second barrier wall pattern on the first barrier wall pattern.

The first barrier wall pattern may include aluminum, and the second barrier wall pattern may include titanium.

The first barrier wall pattern may have a width smaller than a width of the second barrier wall pattern, and the first barrier wall pattern may have a thickness greater than a thickness of the second barrier wall pattern.

The second pattern may have a width greater than a width of the second barrier wall pattern.

The second pattern may have a width greater than a width of the first pattern.

The display panel may include a dummy pattern disposed on the second barrier wall pattern and covered by the second electrode, and the dummy pattern may include the same material as the common layer.

The display panel may include a protective layer disposed between the dummy pattern and the second barrier wall pattern and including an inorganic material.

The second barrier wall pattern that protrudes from the first barrier wall pattern may define a tip portion protruded downward.

The display panel may include a normal barrier wall overlapping the non-light-emitting area and disposed on the pixel definition layer, and the normal barrier wall may be covered by the second electrode.

According to an aspect, there is provided a display panel as set out in claim 1. Additional features are set out in claims 2 to 20. According to an aspect, there is provided a display panel as set out in claim 21. Additional features are set out in claims 22 to 30.According to the disclosure, electrodes may be connected to each other through the barrier wall in the non-display area, and thus, the manufacturing process may be simplified and the manufacturing cost may be reduced. In addition, the electrode covering the barrier wall, which includes different metal layers, may have reduced resistance, and thus, the reliability of the display panel may be improved.

### BRIEF DESCRIPTION OF DRAWINGS

FIG. 1A is a block diagram of an electronic device, according to one or more embodiments;
FIG. 1B is a schematic view of electronic devices according to embodiments of the present disclosure;
FIG. 1C is a perspective view of an electronic device, according to one or more embodiments;
FIG. 2 is a cross-sectional view of an electronic device, according to one or more embodiments;
FIG. 3 is a cross-sectional view of a display panel, according to one or more embodiments;
FIG. 4A is a block diagram of a display module, according to one or more embodiments;
FIG. 4B is an equivalent circuit diagram of one pixel of pixels shown in FIG. 4A;
FIG. 5A is a plan view of a pixel unit, according to one or more embodiments;
FIG. 5B is a plan view of a pixel unit, according to one or more embodiments;
FIG. 6 is a cross-sectional view taken along a line I-I' of FIG. 5A;
FIG. 7 is a cross-sectional view taken along a line II-II' of FIG. 5A;
FIG. 8 is a cross-sectional view of a display panel, according to one or more embodiments;
FIG. 9A is a plan view of a contact area of a display panel, according to one or more embodiments;
FIG. 9B is a plan view of a contact area of a display panel, according to one or more embodiments;
FIG. 10 is a cross-sectional view taken along a line III-III' of FIG. 9A;
FIG. 11 is a cross-sectional view of a contact area of a display panel, according to one or more embodiments;
FIG. 12 is a cross-sectional view of a contact area of a display panel, according to one or more embodiments; and
FIG. 13 is a cross-sectional view of a contact area of a display panel, according to one or more embodiments.

### DETAILED DESCRIPTION

In the present disclosure, it will be understood that when an element (or area, layer, or portion) is referred to as being "on", "connected to" or "coupled to" another element or layer, it can be directly on, connected or coupled to the other element or layer or intervening elements or layers may be present.

Like numerals refer to like elements throughout. In the drawings, the thickness, ratio, and dimension of components are exaggerated for effective description of the technical content. As used herein, the term "and/or" may include any and all combinations of one or more of the associated listed items.

It will be understood that, although the terms first, second, etc. may be used herein to describe various elements, these elements should not be limited by these terms. These terms are only used to distinguish one element from another element. Thus, a first element discussed below could be termed a second element without departing from the teachings of the present disclosure. As used herein, the singular forms, "a", "an" and "the" are intended to include the plural forms as well, unless the context clearly indicates otherwise.

Spatially relative terms, such as "below", "lower", "above", "upper" and the like, may be used herein for ease of description to describe one element or feature's relationship to another elements or features as shown in the figures.

It will be further understood that the terms "include" and/or "including", when used in this specification, specify the presence of stated features, integers, steps, operations, elements, and/or components, but do not preclude the presence or addition of one or more other features, integers, steps, operations, elements, components, and/or groups thereof.

Unless otherwise defined, all terms including technical and scientific terms used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, non-limiting example embodiments of the present disclosure will be described with reference to accompanying drawings.

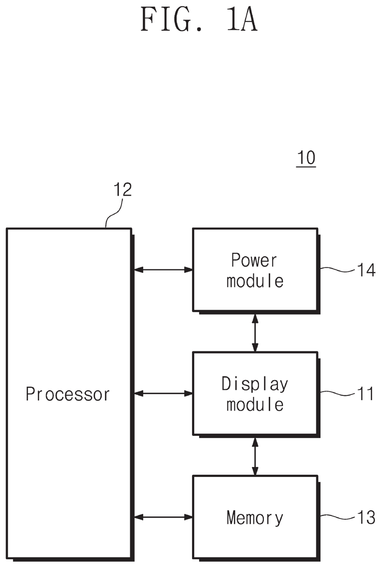

FIG. 1A is a block diagram of an electronic device, according to one or more embodiments. Referring to FIG. 1A, an electronic device 10 may include a display module 11, a processor 12, a memory 13, and a power module 14.

The processor 12 may include at least one of a central processing unit (CPU), an application processor (AP), a graphics processing unit (GPU), a communication processor (CP), an image signal processor (ISP), etc., not being limited thereto.

The memory 13 may store data information required for an operation of at least one of the processor 12 and the display module 11. When the processor 12 executes an application stored in the memory 13, an image data signal and/or an input control signal may be transmitted to the display module 11, and the display module 11 may process the received signals to output image information through a display screen.

The power module 14 may include a power supply, such as a power adapter or a battery device and a power converter that converts power supplied by the power supply to generate power required for an operation of the electronic device 10.

At least one of the components of the electronic device 10 may be included in an electronic device. Among some of the components may be included in the electronic device while the other components may be provided separately from the electronic device. As an example, the electronic device may include the display 11 while the processor 12, the memory 13, and the power module 14 may be provided as separate devices within the electronic device 10 and may not be included in the electronic device.

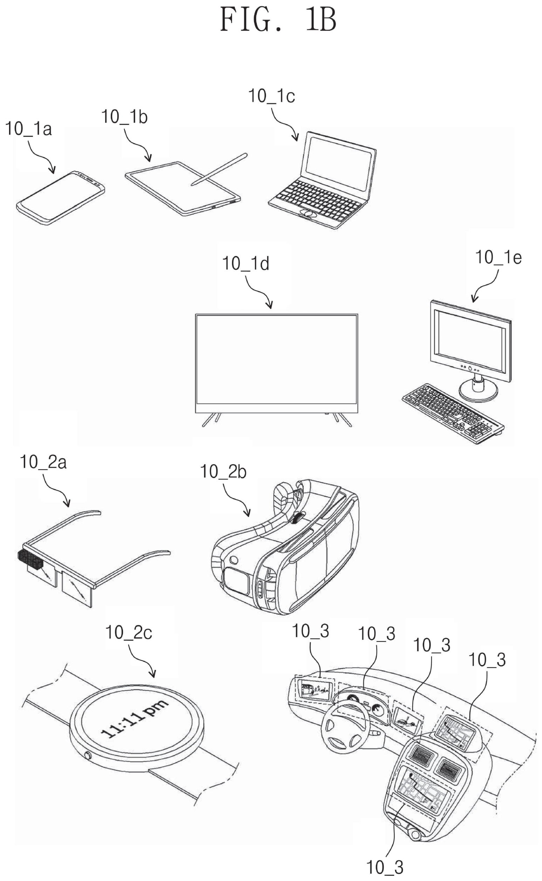

FIG. 1B is a schematic view of electronic devices, according to one or more embodiments.

FIG. 1B illustrates various electronic devices to which the embodiments described herein are applied. These electronic devices for displaying images may be or may include a smartphone 10_1a, a tablet PC 10_1b, a laptop computer 10_1c, a television 10_1d, a desktop monitor 10_1e, etc., a wearable electronic device including a display module, such as a smart glasses 10_2a, a head-mounted display 10_2b, a smartwatch 10_2c, etc., or an in-vehicle electronic device 10_3 including a display module, such as an instrument panel, a center fascia, a dashboard-mounted center information display (CID), a room mirror display, etc.

These electronic devices may further include a module or device having more functions in addition to a display function.

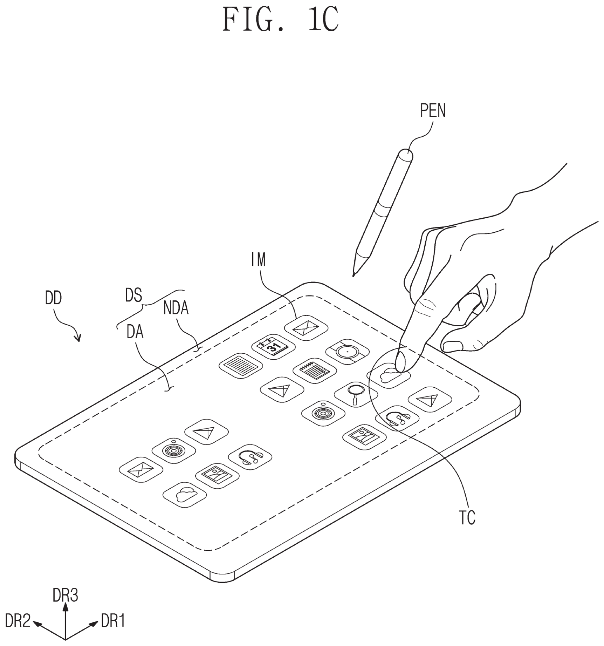

FIG. 1C is a perspective view of an electronic device, according to one or more embodiments. The electronic device described with reference to FIG. 1B may be applied to or include an electronic device DD described with reference to FIG. 1C. As an example, the tablet PC 10_1b described with reference to FIG. 1B may correspond to the electronic device DD of FIG. 1C.

Referring to FIG. 1C, the electronic device DD may include long sides extending in a first direction DR1 and short sides extending in a second direction DR2 intersecting the first direction DR1. Corners where the long sides are connected to the short sides of the electronic device DD may have a curved shape. The corners of the electronic device DD, which have the curved shape, may be defined as rounded corners. The shape of the electronic device DD may be defined as a rectangle with rounded corners. However, this is merely an example of the electronic device DD, and the shape of the electronic device DD should not be limited to the rectangle with rounded corners.

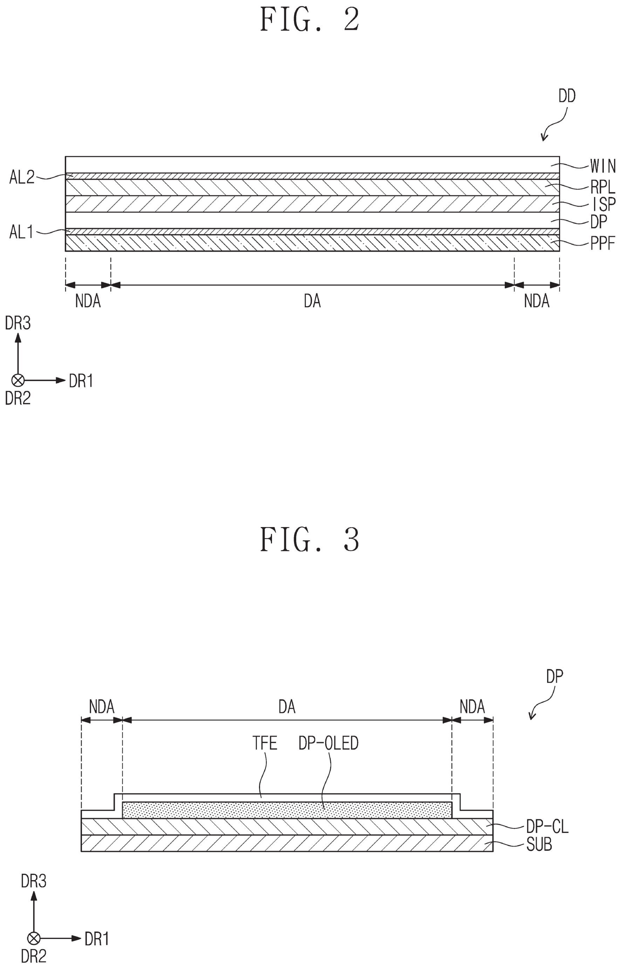

Hereinafter, a direction perpendicular or substantially perpendicular to a plane defined by the first direction DR1 and the second direction DR2 may be referred to as a third direction DR3. For example, the plane defined by the first direction DR1 and the second direction DR2 may be in parallel with a top surface or a bottom surface of a base substrate SUB shown in FIG. 3. In the present disclosure, the expression "when viewed in a plane" and "in plan view" mean a state of being viewed in the third direction DR3.

A front surface of the electronic device DD may be defined as a display surface DS and may include a plane defined by the first direction DR1 and the second direction DR2. Images IM generated by the electronic device DD may be provided through the display surface DS.

The display surface DS may include a display area DA and a non-display area NDA around the display area DA. The display area DA displays the images IM, and the non-display area NDA does not display images like the images IM. The non-display area NDA may surround the display area DA and may define an edge of the electronic device DD, which is printed in a selected color.

The display area DA may have a rectangular shape with rounded corners according to the shape of the electronic device DD. As an example, the display area DA may include sides, which extend in the first direction DR1 and the second direction DR2, of the rectangular shape and rounded corners connecting the sides. Among four sides, sides extending in the first direction DR1 may be defined as long sides, and sides extending in the second direction DR2 may be defined as short sides.

The electronic device DD may sense inputs applied thereto from the outside of the electronic device DD. For example, the electronic device DD may sense a first input generated by a touch pen PEN and a second input generated by a touch TC. The touch pen PEN may be defined as an input device.

The touch pen PEN may be an active pen that outputs a signal. The second input generated by the touch TC may include various types of external inputs, such as a part of a user's body, light, heat, or pressure, not being limited thereto.

The electronic device DD and the touch pen PEN may communicate in both directions. The electronic device DD may provide an uplink signal to the touch pen PEN. For example, the uplink signal may include panel information and information on a protocol version, not being limited thereto.

The touch pen PEN may provide a downlink signal to the electronic device DD. The downlink signal may include a synchronization signal or information on a state of the touch pen PEN. For example, the downlink signal may include coordinate information of the touch pen PEN, battery information of the touch pen PEN, tilt information of the touch pen PEN, and/or various information stored in the touch pen PEN, not being limited thereto.

The electronic device DD may be applied to large-sized electronic apparatuses, such as a television set, a monitor, or an outdoor billboard. In addition, the electronic device DD may be applied to small-sized and medium-sized electronic apparatuses, such as a personal computer (e.g., a notebook computer or a tablet computer), a personal digital assistant, a car navigation unit, a game unit, a smartphone, or a camera. However, these are merely examples, and the electronic device DD may be applied to other electronic apparatuses as long as they do not depart from the present disclosure.

FIG. 2 is a cross-sectional view of an electronic device, according to one or more embodiments. FIG. 3 is a cross-sectional view of a display panel, according to one or more embodiments.

FIG. 2 is a cross-sectional view of the electronic device DD of FIG. 1C when viewed in the second direction DR2. In FIG. 2, some components of the electronic device DD described with reference to FIG. 1C are omitted.

Referring to FIG. 2, the electronic device DD may include a display panel DP, an input sensor ISP, an anti-reflective layer RPL, a window WIN, a panel protective film PPF, and first and second adhesive layers AL1 and AL2.

The display panel DP may be a light emitting type display panel. As an example, the display panel DP may be an organic light emitting display panel or an inorganic light emitting display panel. A light emitting layer of the organic light emitting display panel may include an organic light emitting material. A light emitting layer of the inorganic light emitting display panel may include a quantum dot and a quantum rod. Hereinafter, the organic light emitting display panel will be described as a representative example of the display panel DP.

The input sensor ISP may be disposed on the display panel DP. The input sensor ISP may include a plurality of sensors (not shown) to sense an external input by a capacitive method. The input sensor ISP may be directly manufactured on the display panel DP during the manufacturing of the electronic device DD. Therefore, the input sensor ISP may be directly disposed on the display panel DP. However, embodiments of the present disclosure should not be limited thereto or thereby, and according to one or more other embodiments, the input sensor ISP may be attached to the display panel DP by an adhesive layer after being manufactured separately from the display panel DP.

The anti-reflective layer RPL may be disposed on the input sensor ISP. The anti-reflective layer RPL may be formed directly on the input sensor ISP during the manufacturing of the electronic device DD. However, embodiments of the present disclosure should not be limited thereto or thereby, and according to one or more other embodiments, the anti-reflective layer RPL may be attached to the input sensor ISP by an adhesive layer after being manufactured as a separate panel.

The anti-reflective layer RPL may be defined as an external light antireflection film. The anti-reflective layer RPL may reduce a reflectance with respect to an external light incident to the display panel DP from the above of the electronic device DD. Due to the anti-reflective layer RPL, the external light may not be perceived by a user.

In a case where the external light traveling toward the display panel DP is reflected by the display panel DP and provided to the user, like a mirror, the user may perceive the external light. The anti-reflective layer RPL may include a plurality of color filters (not shown) that display the same colors as the pixels of the display panel DP to prevent the above-mentioned phenomenon.

The color filters may filter the external light to have the same color as the pixels. In this case, the external light may not be perceived by the user. However, embodiments of the present disclosure should not be limited thereto or thereby, and the anti-reflective layer RPL may include a retarder and/or a polarizer to reduce the reflectance of the external light, according to one or more other embodiments.

The window WIN may be disposed on the anti-reflective layer RPL. The window WIN may protect the display panel DP, the input sensor ISP, and the anti-reflective layer RPL from external scratches and impacts.

The panel protective film PPF may be disposed under the display panel DP. The panel protective film PPF may protect a lower portion of the display panel DP. The panel protective film PPF may include a flexible plastic material such as polyethylene terephthalate (PET).

The first adhesive layer AL1 may be disposed between the display panel DP and the panel protective film PPF. The display panel DP and the panel protective film PPF may be coupled to each other by the first adhesive layer AL1. The second adhesive layer AL2 may be disposed between the window WIN and the anti-reflective layer RPL, and the window WIN and the anti-reflective layer RPL may be coupled to each other by the second adhesive layer AL2.

FIG. 3 is a cross-sectional view of the display panel shown in FIG. 2. As an example, FIG. 3 is a cross-sectional view of the display panel DP when viewed in the second direction DR2.

Referring to FIG. 3, the display panel DP may include a base substrate SUB, a circuit element layer DP-CL disposed on the base substrate SUB, a display element layer DP-OLED disposed on the circuit element layer DP-CL, and a thin film encapsulation layer TFE disposed on the display element layer DP-OLED.

The base substrate SUB may include a display area DA and a non-display area NDA around the display area DA. The base substrate SUB may include a glass material or a flexible plastic material such as polyimide (PI). The display element layer DP-OLED may be disposed in the display area DA.

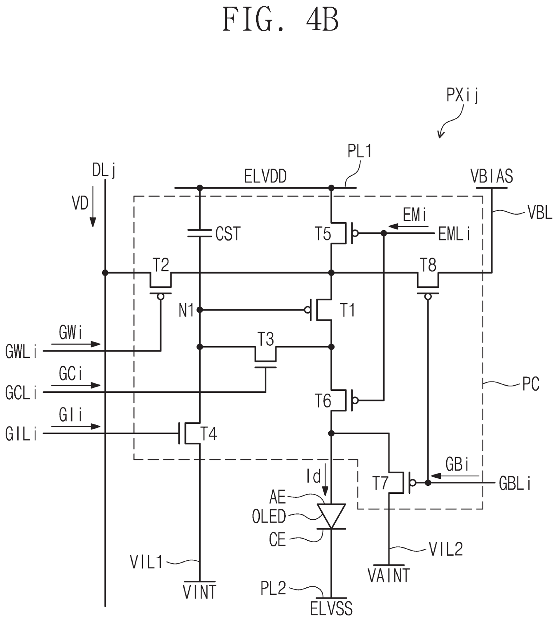

A plurality of pixels may be disposed in the circuit element layer DP-CL and the display element layer DP-OLED. Each pixel may include a transistor disposed in the circuit element layer DP-CL and a light emitting element OLED (refer to FIG. 4B) disposed in the display element layer DP-OLED and connected to the transistor.

The thin film encapsulation layer TFE may be disposed on the circuit element layer DP-CL to cover the display element layer DP-OLED. The thin film encapsulation layer TFE may protect the pixels from moisture, oxygen, and a foreign substance.

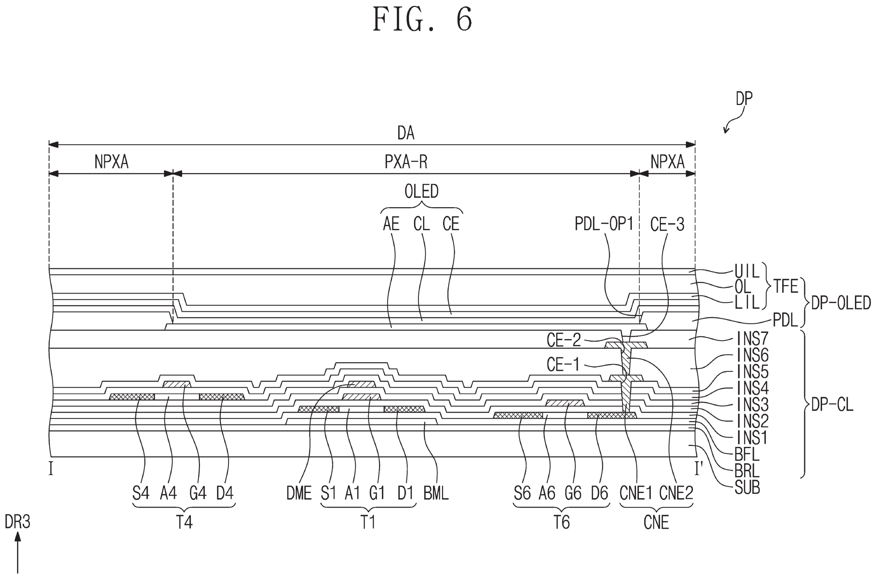

The thin film encapsulation layer TFE may be disposed on the light emitting element OLED at least to partially cover the light emitting element OLED. As shown in FIG. 6, the thin film encapsulation layer TFE may include a first inorganic layer LIL disposed on pixels PXij (refer to FIG. 4B), a second inorganic layer UIL disposed on the first inorganic layer LIL, and an organic layer OL disposed between the first and second inorganic layers LIL and UIL.

The first and second inorganic layers LIL and UIL may include an inorganic material and may protect the pixels from moisture and oxygen. The organic layer OL may include an organic material and may protect the pixels PXij (refer to FIG. 4B) from a foreign substance, e.g., dust particles. The organic layer OL may be formed by a solution process, such as a spin coating process, a slit coating process, an inkjet process, etc.

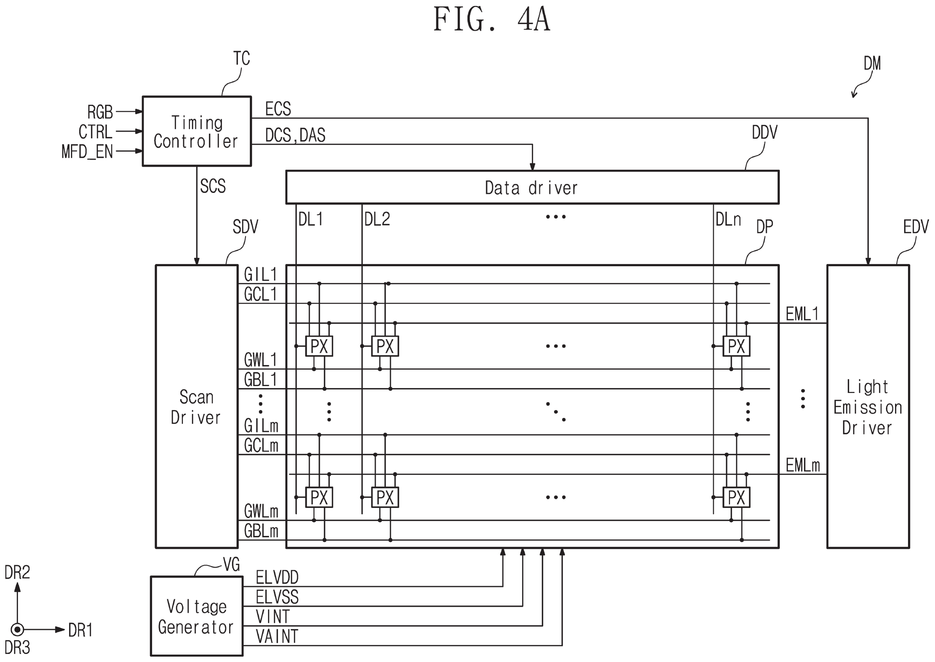

FIG. 4A is a block diagram of a display module, according to one or more embodiments.

Referring to FIG. 4A, a display module DM may include a display panel DP, a timing controller TC, a scan driver SDV, a data driver DDV, a light emission driver EDV, and a voltage generator VG. The display module DM may be or correspond to the display module 11 shown in FIG. 1A, and the display panel DP may be or correspond to the display panel DP shown in FIGS. 2 and 3.

The display panel DP may include a plurality of scan lines GIL1 to GILm, GCL1 to GCLm, GWL1 to GWLm, and GBL1 to GBLm, a plurality of emission lines EML1 to EMLm, a plurality of data lines DL1 to DLn, and a plurality of pixels PX. Each of "m" and "n" is a natural number greater than 0.

The pixels PX may be electrically connected to the scan lines GIL1 to GILm, GCL1 to GCLm, GWL1 to GWLm, and GBL1 to GBLm, the emission lines EML1 to EMLm, and the data lines DL1 to DLn. Each of the pixels PX may be electrically connected to four corresponding scan lines, one corresponding data line, and one corresponding emission line.

The scan lines GIL1 to GILm, GCL1 to GCLm, GWL1 to GWLm, and GBL1 to GBLm may include a plurality of initialization scan lines GIL1 to GILm, a plurality of compensation scan lines GCL1 to GCLm, a plurality of write scan lines GWL1 to GWLm, and a plurality of bias scan lines GBL1 to GBLm.

Each of the pixels PX may be connected to a corresponding initialization scan line among the initialization scan lines GIL1 to GILm, a corresponding compensation scan line among the compensation scan lines GCL1 to GCLm, a corresponding write scan line among the write scan lines GWL1 to GWLm, and a corresponding bias scan line among the bias scan lines GBL1 to GBLm.

The scan lines GIL1 to GILm, GCL1 to GCLm, GWL1 to GWLm, and GBL1 to GBLm may be connected to the scan driver SDV, may extend in the first direction DR1, and may be arranged in the second direction DR2. The emission lines EML1 to EMLm may be connected to the light emission driver EDV, may extend in the first direction DR1, and may be arranged in the second direction DR2. The data lines DL1 to DLn may be connected to the data driver DDV, may extend in the second direction DR2, and may be arranged in the first direction DR1.

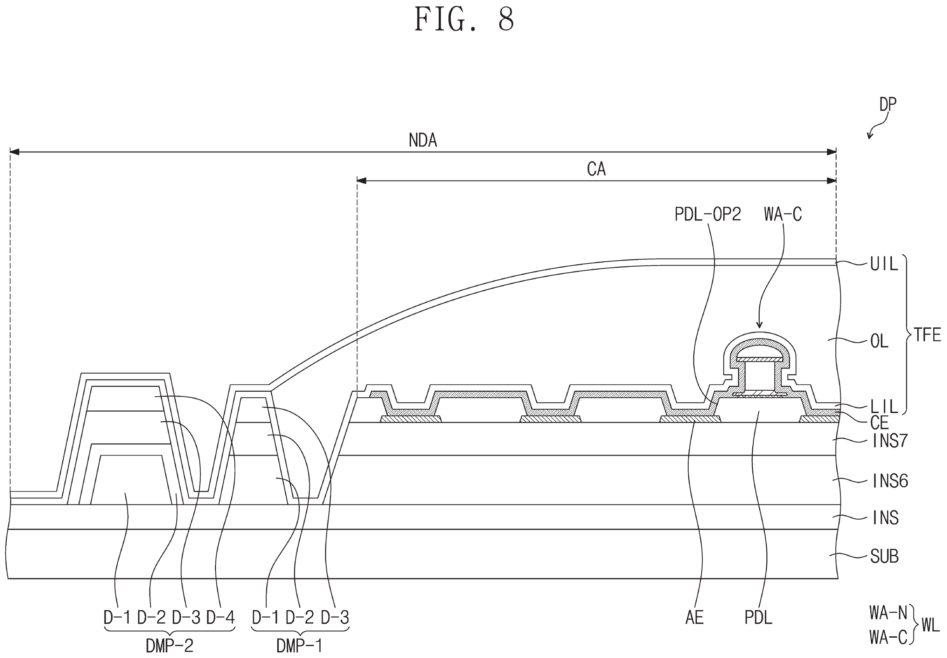

The scan driver SDV, the light emission driver EDV, and the data driver DDV may be included in the display panel DP, and this configuration will be shown below in FIG. 8.

The timing controller TC may receive an image signal RGB and a control signal CTRL. The timing controller TC may convert a data format of the image signal RGB to a data format appropriate to an interface between the data driver DDV and the timing controller TC to generate an image data signal DAS. The timing controller TC may generate a scan control signal SCS, a data control signal DCS, and a light emission control signal ECS in response to the control signal CTRL.

The voltage generator VG may generate voltages required to operate the display panel DP. The voltage generator VG may generate a first driving voltage ELVDD, a second driving voltage ELVSS, a first initialization voltage VINT, and a second initialization voltage VAINT. The first driving voltage ELVDD, the second driving voltage ELVSS, the first initialization voltage VINT, and the second initialization voltage VAINT may be applied to the pixels PX.

The scan driver SDV may receive the scan control signal SCS from the timing controller TC. The scan driver SDV may output scan signals to the scan lines GIL1 to GILm, GCL1 to GCLm, GWL1 to GWLm, and GBL1 to GBLm in response to the scan control signal SCS. The scan signals may be applied to the pixels PX via the scan lines GIL1 to GILm, GCL1 to GCLm, GWL1 to GWLm, and GBL1 to GBLm.

The data driver DDV may receive the data control signal DCS and the image data signal DAS from the timing controller TC. The data driver DDV may convert the image data signal DAS to data signals and may output the data signals. The data signals may be analog voltages corresponding to grayscale levels of the image data signal DAS. The data signals may be applied to the pixels PX via the data lines DL1 to DLn.

The light emission driver EDV may receive the light emission control signal ECS from the timing controller TC. The light emission driver EDV may output emission signals to the emission lines EML1 to EMLm in response to the light emission control signal ECS. The emission signals may be applied to the pixels PX via the emission lines EML1 to EMLm.

The pixels PX may receive data voltages corresponding to the data signals from the data driver DDV in response to the scan signals from the scan driver SDC. The pixels PX may emit a light with luminance corresponding to the data voltages in response to the emission signals to display the images.

FIG. 4B is an equivalent circuit diagram of one pixel of the pixels shown in FIG. 4A.

As an example, FIG. 4B shows a pixel PXij connected to a j-th data line DLj, i-th scan lines GWLi, GCLi, GILi, and GBLi, and an i-th emission line EMLi. Each of "i" and "j" is a natural number greater than 0.

Referring to FIG. 4B, the pixel PXij may include a pixel circuit PC and a light emitting element OLED connected to the pixel circuit PC. The light emitting element OLED may be driven by the pixel circuit PC.

The pixel circuit PC may include a plurality of transistors T1 to T8 and a capacitor CST. The transistors T1 to T8 and the capacitor CST may control an amount of current Id flowing through the light emitting element OLED. The light emitting element OLED may emit a light with a selected luminance corresponding to the amount of current Id provided thereto.

An i-th write scan line GWLi may receive an i-th write scan signal GWi, and an i-th compensation scan line GCLi may receive an i-th compensation scan signal GCi. an i-th initialization scan line GILi may receive an i-th initialization scan signal GIi, and An i-th bias scan line GBLi may receive an i-th bias scan signal GBi. An i-th emission line EMLi may receive an i-th emission signal EMi.

The pixel PXij may be connected to a j-th data line DLj, the i-th write scan line GWLi, the i-th compensation scan line GCLi, the i-th initialization scan line GILi, the i-th bias scan line GBLi, the i-th emission line EMLi, a first initialization line VIL1, a second initialization line VIL2, a bias line VBL, and first and second power lines PL1 and PL2.

The first initialization line VIL1 may receive the first initialization voltage VINT, and the second initialization line VIL2 may receive the second initialization voltage VAINT. The bias line VBL may receive a bias voltage VBIAS. The first power line PL1 may receive the first driving voltage ELVDD, and the second power line PL2 may receive the second driving voltage ELVSS.

Each of the transistors T1 to T8 may include a source electrode, a drain electrode, and a gate electrode. Hereinafter, in FIG. 4B, for the sake of explanation, one of the source electrode and the drain electrode may be referred to as a first electrode, and the other of the source electrode and the drain electrode may be referred to as a second electrode. In addition, the gate electrode may be referred to as a control electrode.

The transistors T1 to T8 may include first, second, third, fourth, fifth, sixth, seventh, and eighth transistors T1, T2, T3, T4, T5, T6, T7, and T8. The first, second, and fifth to eighth transistors T1, T2, and T5 to T8 may be PMOS transistors. The third and fourth transistors T3 and T4 may be NMOS transistors.

The first transistor T1 may be defined as a driving transistor, and the second transistor T2 may be defined as a switching transistor. The third transistor T3 may be defined as a compensation transistor. The fourth transistor T4 and the seventh transistor T7 may be defined as an initialization transistor. The fifth transistor T5 and the sixth transistor T6 may be defined as a light emission control transistor. The eighth transistor T8 may be defined as a bias transistor.

The light emitting element OLED may be defined as an organic light emitting element. The light emitting element OLED may include a first electrode AE and a second electrode CE. The first electrode AE, which may be an anode, may receive the first driving voltage ELVDD through the sixth, first, and fifth transistors T6, T1, and T5. The first driving voltage ELVDD may be applied to the pixel circuit PC via the first power line PL1.

The second electrode CE, which may be a cathode, may receive the second driving voltage ELVSS having a level lower than a level of the first driving voltage ELVDD. The second driving voltage ELVSS may be applied to the pixel circuit PC via the second power line PL2.

The first transistor T1 may be disposed between the fifth transistor T5 and the sixth transistor T6 and may be connected to the fifth transistor T5 and the sixth transistor T6. The first transistor T1 may be connected to the first power line PL1 through the fifth transistor T5 and may be connected to the first electrode AE through the sixth transistor T6.

The first transistor T1 may include the first electrode connected to the first power line PL1 through the fifth transistor T5, the second electrode connected to the first electrode AE through the sixth transistor T6, and the control electrode connected to a first node N1.

The first electrode of the first transistor T1 may be connected to the fifth transistor T5, and the second electrode of the first transistor T1 may be connected to the sixth transistor T6. The first transistor T1 may control an amount of current Id flowing through the light emitting element OLED based on a voltage of the first node N1, which is applied to the control electrode of the first transistor T1.

The second transistor T2 may be disposed between the first transistor T1 and the j-th data line DLj and may be connected to the first transistor T1 and the j-th data line DLj. The second transistor T2 may include a first electrode connected to the j-th data line DLj, a second electrode connected to the first electrode of the first transistor T1, and a control electrode connected to the i-th write scan line GWLi.

The second transistor T2 may be turned on in response to the i-th write scan signal GWi applied through the i-th write scan line GWLi to electrically connect the j-th data line DLj and the first electrode of the first transistor T1. The second transistor T2 may perform a switching operation to provide the data voltage VD corresponding to the above-described data signal and provided through the j-th data line DLj to the first electrode of the first transistor T1.

The third transistor T3 may be connected to the second electrode of the first transistor T1 and the first node N1. The third transistor T3 may include a first electrode connected to the second electrode of the first transistor T1, a second electrode connected to the first node N1, and a control electrode connected to the i-th compensation scan line GCLi.

The third transistor T3 may be turned on in response to the i-th compensation scan signal GCi applied thereto through the i-th compensation scan line GCLi to electrically connect the second electrode of the first transistor T1 and the control electrode of the first transistor T1. When the third transistor T3 is turned on, the first transistor T1 may be diode-connected.

The fourth transistor T4 may be connected to the first node N1. The fourth transistor T4 may include a first electrode connected to the first node N1, a second electrode connected to the first initialization line VIL1, and a control electrode connected to the i-th initialization scan line GILi. The fourth transistor T4 may be turned on in response to the i-th initialization scan signal GIi applied thereto through the i-th initialization scan line GILi to provide the first initialization voltage VINT received through the first initialization line VIL1 to the first node N1.

The fifth transistor T5 may include a first electrode connected to the first power line PL1, a second electrode connected to the first electrode of the first transistor T1, and a control electrode connected to the i-th emission line EMLi.

The sixth transistor T6 may include a first electrode connected to the second electrode of the first transistor T1, a second electrode connected to the first electrode AE, and a control electrode connected to the i-th emission line EMLi.

The fifth transistor T5 and the sixth transistor T6 may be turned on in response to the i-th emission signal EMi applied through the i-th emission line EMLi. Due to the turned-on fifth and sixth transistors T5 and T6, the first driving voltage ELVDD may be provided to the light emitting element OLED, and thus, a driving current Id may flow through the light emitting element OLED. Accordingly, the light emitting element OLED may emit light.

The seventh transistor T7 may include a first electrode connected to the first electrode AE, a second electrode connected to the second initialization line VIL2, and a control electrode connected to the i-th bias scan line GBLi. The seventh transistor T7 may be turned on in response to the i-th bias scan signal GBi applied through the i-th bias scan line GBLi to provide the second initialization voltage VAINT received through the second initialization line VIL2 to the first electrode AE of the light emitting element OLED.

The second initialization voltage VAINT may have a level different from that of the first initialization voltage VINT, however, it should not be limited thereto or thereby. According to one or more other embodiment, the second initialization voltage VAINT may have the same level or substantially the same level as the first initialization voltage VINT.

The seventh transistor T7 may improve an ability to display a true black color of the pixel PXij . When the seventh transistor T7 is turned on, a parasitic capacitance (not shown) of the light emitting element OLED may be discharged. Accordingly, when implementing a black luminance, the light emitting element OLED does not emit a light by a leakage of electrical current from the first transistor T1, and thus the ability to display true black color may be improved.

The capacitor CST may include a first electrode connected to the first power line PL1 and a second electrode connected to the first node N1. When the fifth transistor T5 and the sixth transistor T6 are turned on, an amount of current flowing through the first transistor T1 may be determined based on a voltage charged in the capacitor CST.

The eighth transistor T8 may include a first electrode connected to the bias line VBL, a second electrode connected to the first electrode of the first transistor T1, and a control electrode connected to the i-th bias scan line GBLi.

The eighth transistor T8 may be turned on in response to the i-th bias scan signal GBi and may apply the bias voltage VBIAS, which is applied through the bias line VBL, to the first electrode of the first transistor T1. However, the transistors included in the pixel PXij should not be limited to thereto or thereby.

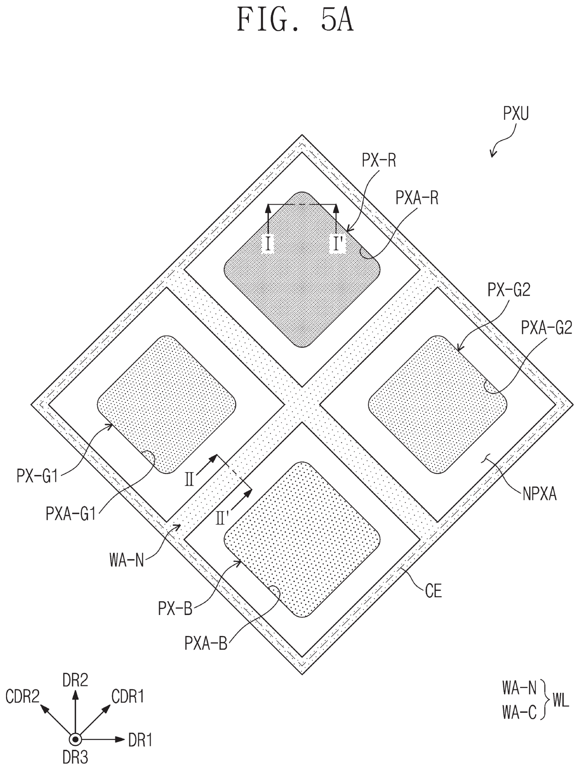

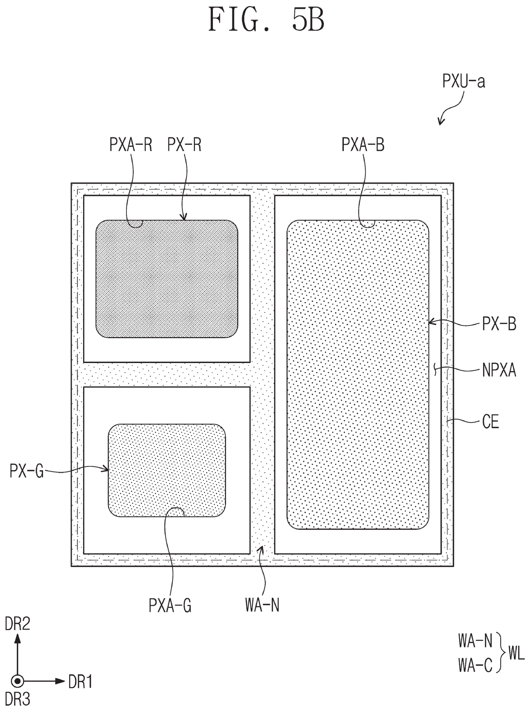

FIG. 5A is a plan view of a pixel unit, according to one or more embodiments. FIG. 5B is a plan view of a pixel unit, according to one or more embodiments.

Referring to FIG. 5A, one pixel unit PXU may include a plurality of pixels described with reference to FIGS. 4A and 4B. The pixel unit PXU may be provided in plural, and the pixel units PXU may be arranged in first and second diagonal directions CDR1 and CDR2 within the display area DA described with reference to FIG. 1C.

The pixel unit PXU may include a first-first pixel PX-G1, a first-second pixel PX-G2, a second PX-R, and a third pixel PX-B. The first-first pixel PX-G1 may generate a green light. The light generated in the first-first pixel PX-G1 may be provided to the display area DA (refer to FIG. 1C) through a first-first light emitting area PXA-G1. The first-first light emitting area PXA-G1 may have a lozenge shape.

The first-second pixel PX-G2 may generate a green light as the first-first pixel PX-G1 does. The light generated in the first-second pixel PX-G2 may be provided to the display area DA (refer to FIG. 1C) through a first-second light emitting area PXA-G2. The first-second light emitting area PXA-G2 may be spaced apart from the first-first light emitting area PXA-G1 in the first direction DR1. The first-second light emitting area PXA-G2 may have a lozenge shape.

The second pixel PX-R may generate a red light. The light generated in the second pixel PX-R may be provided to the display area DA (refer to FIG. 1C) through a second light emitting area PXA-R. The second light emitting area PXA-R may be spaced apart from a third light emitting area PXA-B in the second direction DR2. The second light emitting area PXA-R may be spaced apart from the first-first light emitting area PXA-G1 in the first diagonal direction CDR1 and may be spaced apart from the first-second light emitting area PXA-G2 in the second diagonal direction CDR2. The second light emitting area PXA-R may have a lozenge shape.

The third pixel PX-B may generate a blue light. The light generated in the third pixel PX-B may be provided to the display area DA (refer to FIG. 1C) through the third light emitting area PXA-B. The third light emitting area PXA-B may be spaced apart from the first-second light emitting area PXA-G2 in the first diagonal direction CDR1 and may be spaced apart from the first-first light emitting area PXA-G1 in the second diagonal direction CDR2. The third light emitting area PXA-B may have a lozenge shape.

The second light emitting area PXA-R may have a size greater than a size of each of the first-first light emitting area PXA-G1 and the first-second light emitting area PXA-G2 and smaller than a size of the third light emitting area PXA-B.

An area between the light emitting areas PXA-G1, PXA-G2, PXA-R, and PXA-B may be defined as a non-light-emitting area NPXA.

The display panel DP (refer to FIG. 3) of the electronic device DD according to the present disclosure may include a barrier wall WL. A portion of the barrier wall WL may be disposed in the non-light-emitting area NPXA of the display area DA (refer to FIG. 3). The other portion of the barrier wall WL may be disposed in the non-display area NDA (refer to FIG. 3). The barrier wall WL disposed in the non-display area NDA (refer to FIG. 3) will be described later.

The barrier wall WL disposed in the non-light-emitting area NPXA may surround at least a portion of the light emitting areas PXA-G1, PXA-G2, PXA-R, and PXA-B. That is, the barrier wall WL disposed in the non-light emitting area NPXA may entirely surround the light emitting areas PXA-G1, PXA-G2, PXA-R, and PXA-B or may have a partially opened shape, however, embodiments of the present disclosure should not be limited thereto or thereby.

Referring to FIG. 5B, one pixel unit PXU-a may include the pixels described with reference to FIGS. 4A and 4B. The pixel unit PXU-a may be provided in plural, and the pixel units PXU-a may be arranged in the first and second directions DR1 and DR2 within the display area DA described with reference to FIG. 1C.

The pixel unit PXU-a may include first, second, and third pixels PX-R, PX-B, PX-G. The first pixel PX-R may generate a red light. The light generated in the first pixel PX-R may be provided to the display area DA (refer to FIG. 1C) through a first light emitting area PXA-R. The first light emitting area PXA-R may have a rectangular shape with rounded corners.

The second pixel PX-B may generate a blue light. The light generated in the second pixel PX-B may be provided to the display area DA (refer to FIG. 1C) through a second light emitting area PXA-B. The second light emitting area PXA-B may be spaced apart from the first light emitting area PXA-R in the first direction DR1. When viewed in the first direction DR1, the second light emitting area PXA-B may at least partially overlap the first and third light emitting areas PXA-R and PXA-G. The second light emitting area PXA-B may extend in the second direction DR2 and may have a rectangular shape with rounded corners.

The third pixel PX-G may generate a green light. The light generated in the third pixel PX-G may be provided to the display area DA (refer to FIG. 1C) through the third light emitting area PXA-G. The third light emitting area PXA-G may be spaced apart from the first light emitting area PXA-R in the second direction DR2. The third light emitting area PXA-G may have a rectangular shape with rounded corners.

The first light emitting area PXA-R may have a size greater than a size of the third light emitting area PXA-G and may have a size smaller than a size of the second light emitting area PXA-B.

An area between the light emitting areas PXA-R, PXA-G, and PXA-B may be defined as a non-light-emitting area NPXA.

The display panel DP (refer to FIG. 3) of the electronic device DD according to the present disclosure may include a barrier wall WL. A portion of the barrier wall WL may be disposed in the non-light-emitting area NPXA of the display area DA (refer to FIG. 3). The other portion of the barrier wall WL may be disposed in the non-display area NDA (refer to FIG. 3). The barrier wall WL disposed in the non-display area NDA (refer to FIG. 3) will be described later.

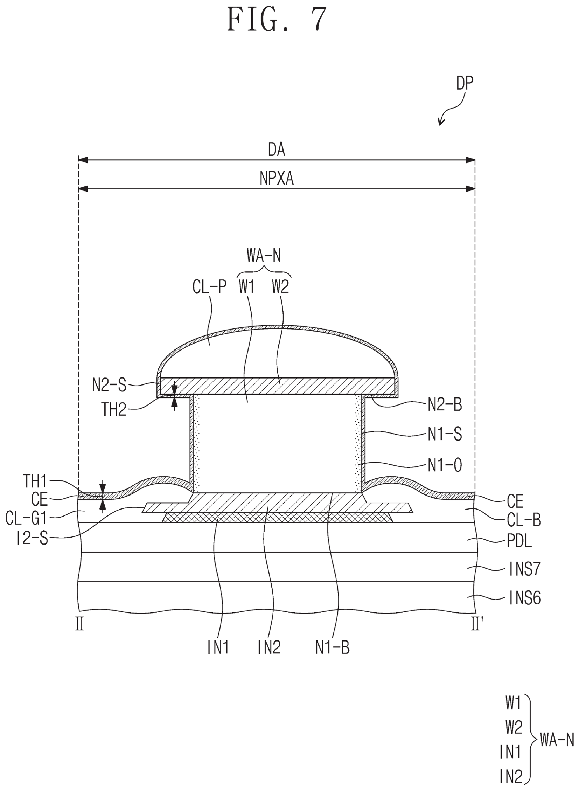

FIG. 6 is a cross-sectional view taken along a line I-I' of FIG. 5A. FIG. 7 is a cross-sectional view taken along a line II-II' of FIG. 5A.

FIG. 6 shows a cross-section of the second pixel PX-R of FIG. 5A. Referring to FIG. 6 along with FIGS. 3, 4A and 4B, the light emitting element OLED may include the first electrode AE, the second electrode CE, and a common layer CL. The common layer CL may include a hole control layer, an electron control layer, and a light emitting layer.

The second electrode CE may be disposed on the first electrode AE, and the common layer CL may be disposed between the first electrode AE and the second electrode CE. The light emitting element OLED may further include a protective layer disposed on the second electrode CE. The protective layer may include an organic material and may prevent components disposed under the protective layer from being damaged in subsequent processes. The protective layer may be omitted.

The first, fourth, and sixth transistors T1, T4, and T6 and the light emitting element OLED may be disposed on the base substrate SUB. The display area DA may include the second light emitting area PXA-R corresponding to the pixel PXij (refer to FIG. 4B) and the non-light-emitting area NPXA adjacent to the second light emitting area PXA-R.

The base substrate SUB may include a glass material or a flexible plastic material such as polyimide (PI). The circuit element layer DP-CL, the display element layer DP-OLED, and the thin film encapsulation layer TFE may be disposed on the base substrate SUB. The circuit element layer DP-CL may be disposed on the base substrate SUB. The circuit element layer DP-CL may include insulating layers and conductive patterns. The display element layer DP-OLED may include the light emitting element OLED and a pixel definition layer PDL.

A barrier layer BRL may be disposed on the base substrate SUB. The barrier layer BRL may increase adhesion between a semiconductor pattern included in the transistors and the base substrate SUB. The barrier layer BRL may include an inorganic material.

A metal layer BML may be disposed on the barrier layer BRL. The metal layer BML may at least partially overlap the first transistor T1 in the third direction DR3. The metal layer BML may receive a constant voltage. When the constant voltage is applied to the metal layer BML, a threshold voltage (Vth) of the first transistor T1 disposed on the metal layer BML may be maintained without being changed.

The metal layer BML may block a light incident from beneath the metal layer BML to the first transistor T1. The metal layer BML may include a reflective metal material. According to one or more other embodiments, the metal layer BML may be omitted.

A buffer layer BFL may be disposed on the barrier layer BRL and may at least partially cover the metal layer BML. The buffer layer BFL may include an inorganic material.

A semiconductor layer S1, A1, and D1 of the first transistor T1 and a semiconductor layer S6, A6, and D6 of the sixth transistor T6 may be disposed on the buffer layer BFL. The semiconductor layers S1, A1, D1, S6, A6, and D6 may include polycrystalline silicon. However, embodiments of the present disclosure should not be limited thereto or thereby, and the semiconductor layers S1, A1, D1, S6, A6, and D6 may include an amorphous silicon.

The semiconductor layers S1, A1, D1, S6, A6, and D6 may be doped with an N-type dopant or a P-type dopant. The semiconductor layers S1, A1, D1, S6, A6, and D6 may include a high-doped region and a low-doped region. The high-doped region may have a conductivity greater than a conductivity of the low-doped region and may substantially serve as a source electrode and a drain electrode of the first and sixth transistors T1 and T6. The low-doped region may substantially correspond to an active region (or a channel) of the first and sixth transistors T1 and T6.

A first source region S1, a first channel region A1, and a first drain region D1 of the first transistor T1 may be formed from the semiconductor layer S1, A1, and D1. A sixth source region S6, a sixth channel region A6, and a sixth drain region D6 of the sixth transistor T6 may be formed from the semiconductor layer S6, A6, and D6. The first channel region A1 may be disposed between the first source region S1 and the first drain region D1. The sixth channel region A6 may be disposed between the sixth source region S6 and the sixth drain region D6.

A first insulating layer INS1 may be disposed on the buffer layer BFL to at least partially cover the semiconductor layers S1, A1, D1, S6, A6, and D6. A first gate electrode G1 (or control electrode) of the first transistor T1 and a sixth gate electrode G6 (or control electrode) of the sixth transistor T6 may be disposed on the first insulating layer INS1. When viewed in a plane, the first gate electrode G1 may at least partially overlap the first channel region A1, and the sixth gate electrode G6 may at least partially overlap the sixth channel region A6.

A source region, a channel region, a drain region, and the gate electrode of each of the second, fifth, and seventh transistors T2, T5, and T7 may have the same or substantially the same structure as those of the first and sixth transistors T1 and T6.

A second insulating layer INS2 may be disposed on the first insulating layer INS1 to at least partially cover the first gate electrode G1 and the sixth gate electrode G6. A dummy electrode DME may be disposed on the second insulating layer INS2. The dummy electrode DME may be disposed on the first gate electrode G1 and may at least partially overlap the first gate electrode G1 when viewed in a plane. The dummy electrode DME may form a capacitor together with the first gate electrode G1.

A third insulating layer INS3 may be disposed on the second insulating layer INS2 to at least partially cover the dummy electrode DME. A semiconductor layer S4, A4, and D4 of the fourth transistor T4 may be disposed on the third insulating layer INS3. The semiconductor layer S4, A4, and D4 may include an oxide semiconductor containing a metal oxide. The oxide semiconductor may include a crystalline or amorphous oxide semiconductor.

The semiconductor layer S4, A4, and D4 may include a plurality of areas distinguished from each other depending on whether the metal oxide is reduced. The area (hereinafter, referred to as a "reduced area") in which the metal oxide is reduced may have a conductivity greater than that of the area (hereinafter, referred to as a "non-reduced area") in which the metal oxide is not reduced. The reduced area may substantially serve as a source electrode and a drain electrode of the fourth transistor T4. The non-reduced area may substantially correspond to an active region (or a channel) of the fourth transistor T4.

A fourth source region S4, a fourth channel region A4, and a fourth drain region D4 of the fourth transistor T4 may be formed from the semiconductor layer S4, A4, and D4. The fourth channel region A4 may be disposed between the fourth source region S4 and the fourth drain region D4.

A fourth insulating layer INS4 may be disposed on the third insulating layer INS3 to at least partially cover the semiconductor layer S4, A4, and D4. A fourth gate electrode G4 of the fourth transistor T4 may be disposed on the fourth insulating layer INS4. When viewed in a plane, the fourth gate electrode G4 may at least partially overlap the fourth channel region A4.

A fifth insulating layer INS5 may be disposed on the fourth insulating layer INS4 to at least partially cover the fourth gate electrode G4. A source region, a channel region, a drain region, and the gate electrode of the third transistor T3 may have substantially the same structure as the fourth transistor T4.

The barrier layer BRL, the buffer layer BFL, and the first to fifth insulating layers INS1 to INS5 may include an inorganic material. As an example, the barrier layer BRL, the buffer layer BFL, and the first to fifth insulating layers INS1 to INS5 may include one of silicon oxide and silicon nitride, or one insulating layer may have a multilayer structure of inorganic layers, however, the present disclosure should not be particularly limited. The multiple inorganic layers may have a structure in which a layer including silicon nitride and a layer including silicon oxide are alternately stacked one on another.

A connection electrode CNE may be disposed between the sixth transistor T6 and the light emitting element OLED. The connection electrode CNE may electrically connect the sixth transistor T6 and the light emitting element OLED. The connection electrode CNE may include a first connection electrode CNE1 and a second connection electrode CNE2 disposed on the first connection electrode CNE1.

The first connection electrode CNE1 may be disposed on the fifth insulating layer INS5 and may be connected to the sixth drain region D6 via a first contact hole CE-1 defined through the first to fifth insulating layers INS1 to INS5. A sixth insulating layer INS6 may be disposed on the fifth insulating layer INS5 to at least partially cover the first connection electrode CNE1.

The second connection electrode CNE2 may be disposed on the sixth insulating layer INS6. The second connection electrode CNE2 may be connected to the first connection electrode CNE1 via a second contact hole CE-2 defined through the sixth insulating layer INS6. The first electrode AE may be connected to the second connection electrode CNE2 via a third contact hole CE-3 defined through the seventh insulating layer INS7.

A seventh insulating layer INS7 may be disposed on the sixth insulating layer INS6 to at least partially cover the second connection electrode CNE2. The sixth and seventh insulating layers INS6 and INS7 may include an organic material.

The pixel definition layer PDL may be disposed on the seventh insulating layer INS7. A first opening PDL-OP1 may be defined through the pixel definition layer PDL to expose at least a portion of the first electrode AE. The pixel definition layer PDL may include an organic material. In addition, the pixel definition layer PDL may have a selected color, however, embodiments of the present disclosure should not be particularly limited.

The common layer CL and the second electrode CE, which are included in the light emitting element OLED, may be disposed on the pixel definition layer PDL.

The thin film encapsulation layer TFE may be disposed on the light emitting element OLED and may at least partially cover the light emitting element OLED. The thin film encapsulation layer TFE may be disposed in the entire area of the display area DA. The thin film encapsulation layer TFE may include inorganic layers and an organic layer disposed between the inorganic layers, however, embodiments of the present disclosure should not be limited thereto or thereby.

FIG. 7 shows a cross-section of a normal barrier wall WA-N disposed in the non-light-emitting area NPXA. The barrier wall WL described with reference to FIG. 5A may include the normal barrier wall WA-N and a border barrier wall WA-C (refer to FIG. 8). The normal barrier wall WA-N may be disposed in the non-light-emitting area NPXA of the display area DA, and the border barrier wall WA-C (refer to FIG. 8) may be disposed in a contact area CA (refer to FIG. 8) of the non-display area NDA (refer to FIG. 8).

Referring to FIG. 7, the normal barrier wall WA-N may be disposed in the non-light-emitting area NPXA of the display area DA. The normal barrier wall WA-N may include a first insulating pattern IN1, a second insulating pattern IN2, a first barrier wall pattern W1, and a second barrier wall pattern W2.

The first insulating pattern IN1 may be disposed on the pixel definition layer PDL. The first insulating pattern IN1 may include an inorganic material. The second insulating pattern IN2 may be disposed on the first insulating pattern IN1. The second insulating pattern IN2 may include an inorganic material different from that of the first insulating pattern IN1.

As an example, the first insulating pattern IN1 may include at least one of indium zinc oxide, indium gallium zinc oxide, and indium tin oxide, and the second insulating pattern IN2 may include at least one of silicon oxide, silicon oxynitride, and silicon nitride.

The first insulating pattern IN1 may be used to disconnect or isolate a P-type hole injection layer from among layers included in a common layer CL-G1. Accordingly, the first insulating pattern IN1 may have a thickness greater than a thickness of the P-type hole injection layer among the layers included in the common layer CL-G1.

A width of the second insulating pattern IN2 may be greater than a width of the first insulating pattern IN1 when viewed in a cross-section. The difference in width may be caused by a difference in etch rate between the first insulating pattern IN1 and the second insulating pattern IN2 with respect to an etching solution.

A step difference may be formed between a portion of the second insulating pattern IN2, which at least partially overlaps the first barrier wall pattern W1 in the third direction DR3, and a portion of the second insulating pattern IN2, which does not overlap the first barrier wall pattern W1. Therefore, the portion of the second insulating pattern IN2, which at least partially overlaps the first barrier wall pattern W1, may have a thickness greater than a thickness of the portion of the second insulating pattern IN2, which does not overlap the first barrier wall pattern W1.

The common layers CL-G1 and CL-B included in different pixels PX-G1 and PX-B may be disconnected from each other by the first insulating pattern IN1 and the second insulating pattern IN2, and the barrier wall WL may be disposed between the common layers CL-G1 and CL-B. The common layers CL-G1 and CL-B disconnected from each other may be in contact with side surfaces of the first insulating pattern IN1 and the second insulating pattern IN2. However, embodiments of the present disclosure should not be limited thereto or thereby, and the common layers CL-G1 and CL-B disconnected from each other may be in contact with a side surface N1-S of the first barrier wall pattern W1.

The first barrier wall pattern W1 may be disposed on the second insulating pattern IN2. The first barrier wall pattern W1 may include a metal material. As an example, the first barrier wall pattern W1 may include aluminum. In a case where the first barrier wall pattern W1 includes aluminum, the side surface N1-S of the first barrier wall pattern W1 may be oxidized and may lose its conductivity. Accordingly, the side surface N1-S of the first barrier wall pattern W1 may include a non-conductive area N1-O.

The second barrier wall pattern W2 may be disposed on the first barrier wall pattern W1. The second barrier wall pattern W2 may include a metal different from that of the first barrier wall pattern W1. As an example, the second barrier wall pattern W2 may include titanium.

The first barrier wall pattern W1 may have a thickness greater than a thickness of the second barrier wall pattern W2, and the first barrier wall pattern W1 may have a width smaller than a width of the second barrier wall pattern W2. A portion of the second barrier wall pattern W2 may protrude from the first barrier wall pattern W1 and may be exposed without being covered by the first barrier wall pattern W1.

Therefore, a lower surface N2-B of the second barrier wall pattern W2 may be exposed without being covered by the first barrier wall pattern W1. This structure may be formed due to a difference in etch rate between the first barrier wall pattern W1 and the second barrier wall pattern W2 with respect to an etching solution. The first barrier wall pattern W1 and the second barrier wall pattern W2 may be defined as having a tip structure.

The second insulating pattern IN2 may have a width that is greater than or equal to the width of the second barrier wall pattern W2, however, embodiments of the present disclosure should not be particularly limited.

The second electrode CE may extend from the second light emitting area PXA-R shown in FIG. 6 to the non-light-emitting area NPXA and may at least partially cover (or surround) the normal barrier wall WA-N. For example, the second electrode CE may entirely cover (or surround) the normal barrier wall WA-N. The second electrode CE overlapping the normal barrier wall WA-N may be in contact with the side surface N1-S of the first barrier wall pattern W1, the lower surface N2-B of the second barrier wall pattern W2 exposed without being covered by the first barrier wall pattern W1, and a side surface N2-S of the second barrier wall pattern W2.

The second electrode CE may include indium zinc oxide. The second electrode CE may be formed through a sputtering process.

As described above, in a case where the side surface N1-S of the first barrier wall pattern W1 includes the non-conductive area N1-O that is oxidized and loses its conductivity, the portion of the second electrode CE, which at least partially covers the normal barrier wall WA-N, may be connected to the other portion of the second electrode CE through the lower surface N2-B of the second barrier wall pattern W2 exposed without being covered by the first barrier wall pattern W1 and an inner portion of the first barrier wall pattern W1. These descriptions may be equally applied to the border barrier wall WA-C.

A first thickness TH1 of the second electrode CE disposed on the common layers CL-G1 and CL-B may be greater than a second thickness TH2 of the second electrode CE surrounding the normal barrier wall WA-N. The second thickness TH2 may be about 20% to about 25% of the first thickness TH1.

A dummy pattern CL-P may be disposed on the second barrier wall pattern W2. The dummy pattern CL-P may be at least partially covered by the second electrode CE. For example, the dummy pattern CL-P may be entirely covered by the second electrode CE. The dummy pattern CL-P may be formed through the same process as the common layers CL-G1 and CL-B and may include the same material as the common layers CL-G1 and CL-B. The common layers CL-G1 and CL-B may be disconnected from each other on the second barrier wall pattern W2 by the tip structure of the barrier wall WL, and the disconnected portions of the common layer CL-G1 and CL-B may be defined as the dummy pattern CL-P.

As the normal barrier wall WA-N, which include different metal layers, and the second electrode CE are in contact with each other in the display area DA, a resistance of the second electrode CE may be reduced.

FIG. 8 is a cross-sectional view of a display panel, according to one or more embodiments. FIG. 8 is a cross-sectional view of a portion of the display panel DP of FIGS. 2-3 overlapping the non-display area NDA in the third direction DR3. Among the components described in FIG. 6, components from the barrier layer BRL disposed on the base substrate SUB up to the fifth insulating layer INS5 are simply illustrated as an insulating layer INS. At least one of the components from the barrier layer BRL to the fifth insulating layer INS5 may be omitted, and it should not be particularly limited.

The display panel DP may include first and second dam portions DMP-1 and DMP-2 arranged at an outer edge of the non-display area NDA. The first dam portion DMP-1 may be arranged closer to the display area DA (refer to FIG. 6) than the second dam portion DMP-2 is. The first dam portion DMP-1 and the second dam portion DMP-2 may be arranged in the non-display area NDA and may surround at least a portion of the contact area CA.

Each of the first dam portion DMP-1 and the second dam portion DMP-2 may include dam patterns in which organic layers are stacked. Each of the dam patterns may include the same material as a layer including an organic material among the insulating layers described with reference to FIG. 6.

The first dam portion DMP-1 may include first, second, and third dam patterns D-1, D-2, and D-3 sequentially stacked on the insulating layer INS. The second dam portion DMP-2 may include first, second, third, and fourth dam patterns D-1, D-2, D-3, and D-4 sequentially stacked on the insulating layer INS. The first, second, and third dam patterns D-1, D-2, and D-3 may include the same materials as the sixth insulating layer INS6, the seventh insulating layer INS7, and the pixel definition layer PDL, respectively. The fourth dam pattern D-4 may include a material corresponding to a spacer that is disposed on the pixel definition layer PDL and serves as a supporter in a deposition process.

At least one of the first dam portion DMP-1 and the second dam portion DMP-2 may define a boundary of the organic layer OL (shown in FIG. 6) in the non-display area NDA. In the process of forming the organic layer OL through a solution process such as a spin coating, slit coating, or inkjet process, the height of the first dam portion DMP-1 may prevent the solution from overflowing.

The non-display area NDA of the display panel DP may include the contact area CA. The contact area CA may be defined as an area in which the second electrode CE commonly arranged in the light emitting element OLED comes into contact with the first electrode AE.

The barrier wall WL may be disposed in the contact area CA. In more detail, the border barrier wall WA-C included in the barrier wall WL may be disposed. The barrier wall WL may be disposed on the pixel definition layer PDL. In the contact area CA, a second opening PDL-OP2 may be defined through the pixel definition layer PDL to expose at least a portion of the first electrode AE. That is, the first openings PDL-OP1 (refer to FIG. 6) at least partially overlapping in the third direction DR3 the first electrode AE included in each light emitting element OLED may be defined through the pixel definition layer PDL, and the second openings PDL-OP2 that expose portions of the first electrode AE arranged as a single pattern in the non-display area NDA may be defined through the pixel definition layer PDL.

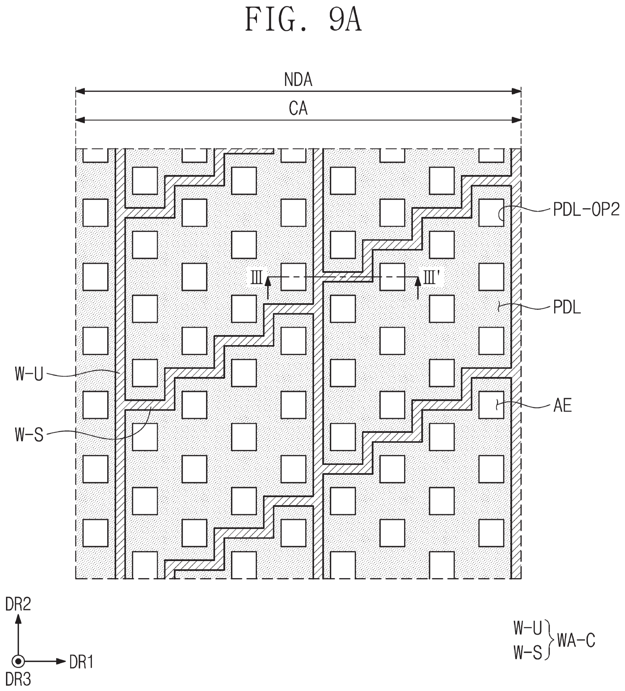

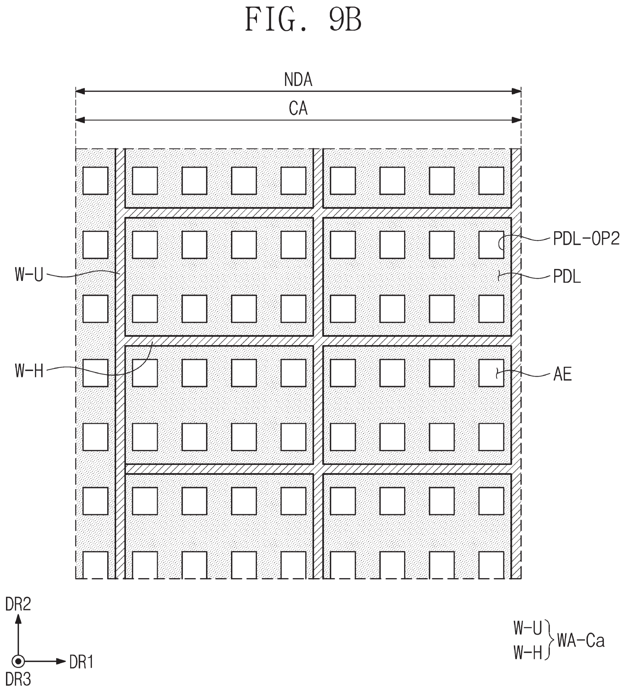

FIG. 9A is a plan view of a contact area of a display panel, according to one or more embodiments. FIG. 9B is a plan view of a contact area of a display panel, according to one or more other embodiments. FIGS. 9A and 9B show shapes of border barrier walls WA-C and WA-Ca when viewed in the plane.

Referring to FIG. 9A along with FIG. 8, the border barrier wall WA-C may include first portions W-U and second portions W-S. The first portions W-U and the second portions W-S may be disposed on the pixel definition layer PDL and may be spaced apart from the second opening PDL-OP2. The first portions W-U and the second portions W-S substantially form a single pattern, but they are distinguished for the convenience of explanation.

Each of the first portions W-U may extend in the second direction DR2, and the first portions W-U may be spaced apart from each other in the first direction DR1. The second portions W-S may be disposed between the first portions W-U. Among the first portions W-U, the first portion W-U closest to the display area DA (refer to FIG. 6) may be connected to the normal barrier wall WA-N (refer to FIG. 7) extending from the display area DA (refer to FIG. 6). Accordingly, the normal barrier wall WA-N (refer to FIG. 7) may be integrally provided with the border barrier wall WA-C as a pattern.

Each of the second portions W-S may have a stepped shape. The second portions W-S may be spaced apart from each other in the second direction DR2 between two first portions W-U adjacent to each other in the first direction DR1.

Referring to FIG. 9B along with FIG. 8, the border barrier wall WA-Ca may include first portions W-U and second portions W-H. The first portions W-U and the second portions W-H may be disposed on a pixel definition layer PDL and may be spaced apart from a second opening PDL-OP2. The first portions W-U and the second portions W-H substantially form a single pattern, but they are distinguished for the convenience of explanation.

Each of the first portions W-U may extend in the second direction DR2, and the first portions W-U may be spaced apart from each other in the first direction DR1. The second portions W-H may be disposed between the first portions W-U.

Each of the second portions W-H may extend in the first direction DR1, and the second portions W-H may be spaced apart from each other in the second direction DR2 between two first portions W-U adjacent to each other in the first direction DR1.

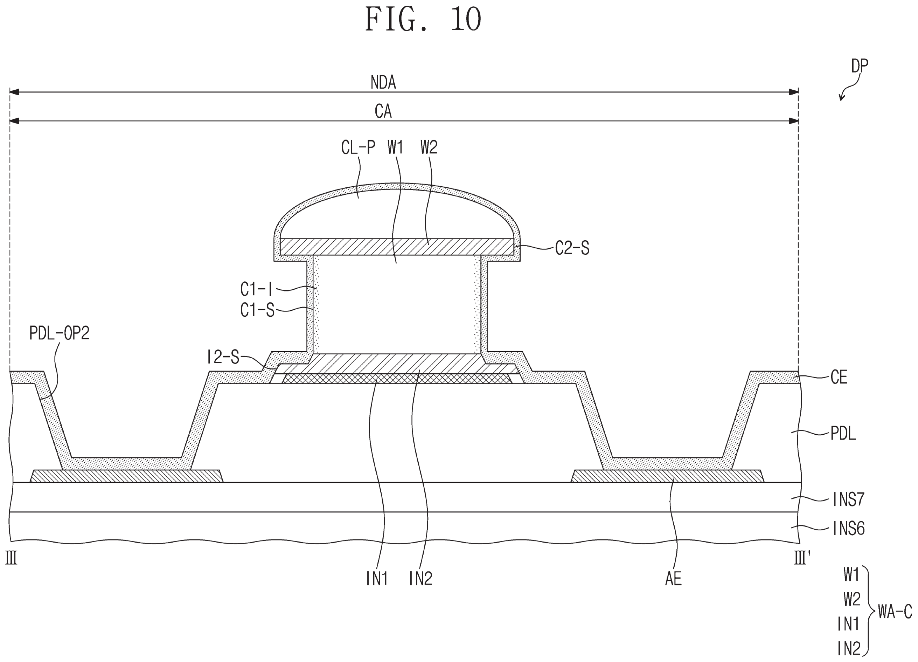

FIG. 10 is a cross-sectional view taken along a line III-III' of FIG. 9A.

Referring to FIG. 10, a border barrier wall WA-C may be disposed on the pixel definition layer PDL in the contact area CA. The border barrier wall WA-C may have the same layer structure as the normal barrier wall WA-N described with reference to FIG. 7. The border barrier wall WA-C may include a first insulating pattern IN1, a second insulating pattern IN2, a first barrier wall pattern W1, and a second barrier wall pattern W2.

The first insulating pattern IN1 may be disposed on the pixel definition layer PDL. The first insulating pattern IN1 may include an inorganic material. The second insulating pattern IN2 may be disposed on the first insulating pattern IN1. The second insulating pattern IN2 may include an inorganic material different from that of the first insulating pattern IN1.

As an example, the first insulating pattern IN1 may include at least one of indium zinc oxide, indium gallium zinc oxide, and indium tin oxide, and the second insulating pattern IN2 may include at least one of silicon oxide, silicon oxynitride, and silicon nitride.

The first insulating pattern IN1 may be used to disconnect a P-type hole injection layer among layers included in the common layer CL-G1. Accordingly, the first insulating pattern IN1 may have a thickness greater than a thickness of the P-type hole injection layer among the layers included in the common layer CL-G1.

A width of the second insulating pattern IN2 may be greater than a width of the first insulating pattern IN1 when viewed in the cross-section. The difference in width may be caused by the difference in etch rate between the first insulating pattern IN1 and the second insulating pattern IN2 with respect to an etching solution.

A thickness of the second electrode CE may be greater than the thickness of the first insulating pattern IN1. Accordingly, even though the second electrode CE at least partially covers the border barrier wall WA-C, the second electrode CE may not be disconnected by the first insulating pattern IN1.

A step difference may be formed between a portion of the second insulating pattern IN2, which overlaps the first barrier wall pattern W1, and a portion of the second insulating pattern IN2, which does not overlap the first barrier wall pattern W1.

The first barrier wall pattern W1 may be disposed on the second insulating pattern IN2. The first barrier wall pattern W1 may include a metal material. As an example, the first barrier wall pattern W1 may include aluminum. In a case where the first barrier wall pattern W1 includes aluminum, a side surface C1-S of the first barrier wall pattern W1 may be oxidized and may lose its conductivity. Accordingly, the side surface C1-S of the first barrier wall pattern W1 may include a non-conductive area C1-I.

The second barrier wall pattern W2 may be disposed on the first barrier wall pattern W1. The second barrier wall pattern W2 may include a metal different from that of the first barrier wall pattern W1. As an example, the second barrier wall pattern W2 may include titanium.

The first barrier wall pattern W1 may have a thickness greater than a thickness of the second barrier wall pattern W2, and the first barrier wall pattern W1 may have a width smaller than a width of the second barrier wall pattern W2. A portion of the second barrier wall pattern W2 may protrude from the first barrier wall pattern W1 and may be exposed without being covered by the first barrier wall pattern W1.

Therefore, a lower surface of the second barrier wall pattern W2 may be exposed without being covered by the first barrier wall pattern W1. This structure may be formed due to the difference in etch rate between the first barrier wall pattern W1 and the second barrier wall pattern W2 with respect to an etching solution. The first barrier wall pattern W1 and the second barrier wall pattern W2 may be defined as having a tip structure.

The second insulating pattern IN2 may have the width that is greater than or equal to the width of the second barrier wall pattern W2, however, embodiments of the present disclosure should not be particularly limited.

A dummy pattern CL-P may be disposed on the second barrier wall pattern W2. The dummy pattern CL-P may be at least partially covered by the second electrode CE. For example, the dummy pattern CL-P may be entirely covered by the second electrode CE. The dummy pattern CL-P may be formed through the same process as the common layer CL-G1 and CL-B (refer to FIG. 7) and may include the same material as the common layer CL-G1 and CL-B (refer to FIG. 7).

The insulating patterns and the barrier wall patterns included in the normal barrier wall WA-N may include the same material as the insulating patterns and the barrier wall patterns included in the border barrier wall WA-C and may be patterned through the same process as the insulating patterns and the barrier wall patterns included in the border barrier wall WA-C.

The second electrode CE may be connected to the first electrode AE in the contact area CA of the non-display area NDA. The second electrode CE may be commonly disposed in the light emitting elements OLED described with reference to FIG. 6 and may extend from the display area DA to the non-display area NDA.

The second opening PDL-OP2 may be defined through the pixel definition layer PDL at least partially overlapping the contact area CA in the third direction DR3 to expose a portion of the first electrode AE. The second electrode CE extending to the non-display area NDA may at least partially cover the pixel definition layer PDL and may be connected to the first electrode AE. A portion of the second electrode CE may at least partially cover the border barrier wall WA-C disposed on the pixel definition layer PDL.

The second electrode CE may comprise a first portion on a first side of the border barrier wall WA-C and a second portion on a second side of the border barrier wall WA-C opposite to the first side, and the first portion and the second portion may be connected across the border barrier wall WA-C. As the second electrode CE at least partially covers the border barrier wall WA-C including different metal layers in the contact area CA, a resistance of the second electrode CE may be reduced.

The resistance of the second electrode CE may be reduced by the border barrier wall WA-C in the non-display area NDA, and the second electrode CE may be in contact with the first electrode AE. Therefore, a separate mask process that connects the second electrode CE and the second power line PL2 (refer to FIG. 4B) through the normal barrier wall WA-N in the display area DA may be omitted. Thus, a manufacturing process of the electronic device DD may be simplified, and a manufacturing cost of the electronic device DD may be reduced.

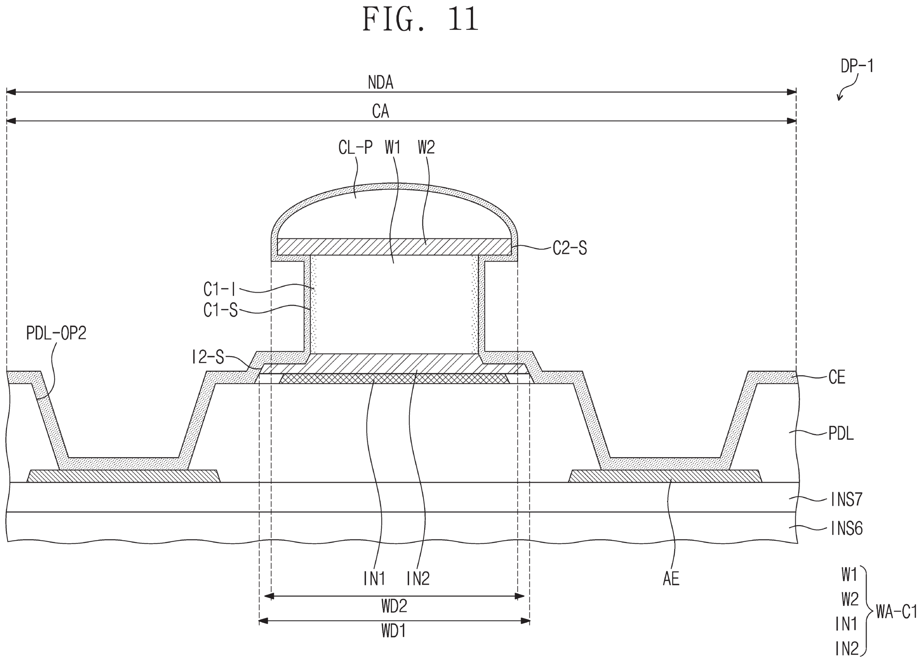

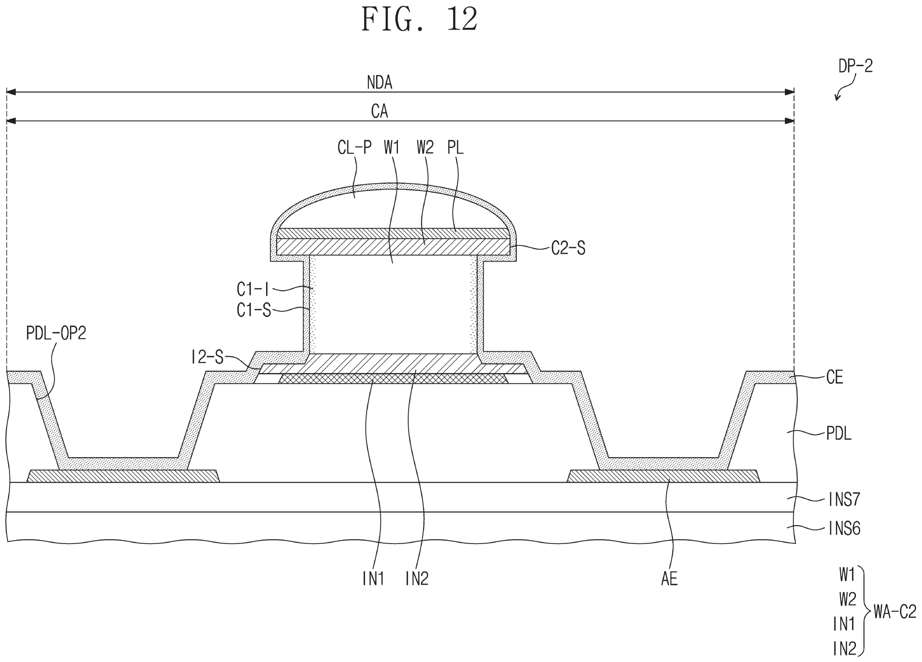

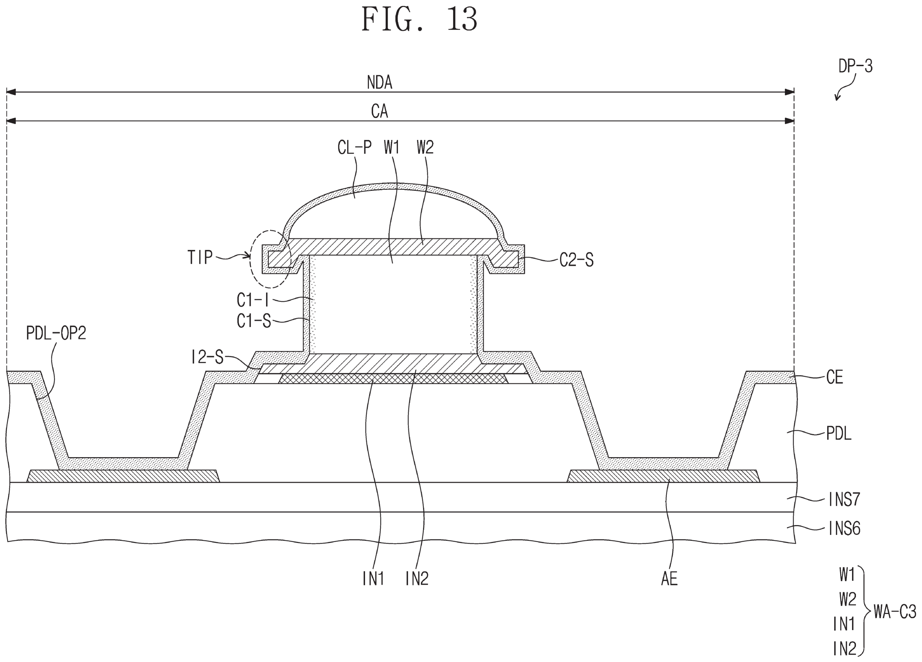

FIG. 11 is a cross-sectional view of a contact area of a display panel, according to one or more embodiments. FIG. 12 is a cross-sectional view of a contact area of a display panel, according to one or more other embodiments. FIG. 13 is a cross-sectional view of a contact area of a display panel, according to still one or more other embodiments. In FIGS. 11 to 13, the same/similar reference numerals denote the same/similar elements in FIG. 10, and thus, detailed descriptions of the same elements will be omitted.

Referring to FIG. 11, a display panel DP-1 may include a border barrier wall WA-C1 disposed in a contact area CA of a non-display area NDA. The border barrier wall WA-C1 may be disposed on a pixel definition layer PDL. The border barrier wall WA-C1 may include a first insulating pattern IN1 disposed on the pixel definition layer PDL, a second insulating pattern IN2 disposed on the first insulating pattern IN1, a first barrier wall pattern W1 disposed on the second insulating pattern IN2, and a second barrier wall pattern W2 disposed on the first barrier wall pattern W1.

The second insulating pattern IN2 may have a first width WD1 greater than a second width WD2 of the second barrier wall pattern W2. Accordingly, a side surface I2-S of the second insulating pattern IN2 may protrude further toward the outside of the border barrier wall WA-C than a side surface C2-S of the second barrier wall pattern W2. A normal barrier wall WA-N (refer to FIG. 7) may have the same shape as that of the border barrier wall WA-C1. Accordingly, when a common layer CL-G1 and CL-B (refer to FIG. 7) is formed, a thickness of a light emitting layer included in the common layer CL-G1 and CL-B (refer to FIG. 7) may be secured, and a P-type hole injection layer included in the common layer CL-G1 and CL-B (refer to FIG. 7) may be easily disconnected.

Referring to FIG. 12, a display panel DP-2 may include a border barrier wall WA-C2 disposed in a contact area CA of a non-display area NDA. The border barrier wall WA-C2 may be disposed on a pixel definition layer PDL. The border barrier wall WA-C2 may include a first insulating pattern IN1 disposed on the pixel definition layer PDL, a second insulating pattern IN2 disposed on the first insulating pattern IN1, a first barrier wall pattern W1 disposed on the second insulating pattern IN2, and a second barrier wall pattern W2 disposed on the first barrier wall pattern W1.

The border barrier wall WA-C2 may further include a protective layer PL. The protective layer PL may be disposed on the second barrier wall pattern W2 and may be at least partially covered by a dummy pattern CL-P. The protective layer PL may be disposed on an upper surface of the second barrier wall pattern W2. The protective layer PL may be disposed on the second barrier wall pattern W2 and may prevent the second barrier wall pattern W2 from being damaged in subsequent processes.

The protective layer PL may include an inorganic material. As an example, the protective layer PL may include at least one of silicon nitride and silicon oxide.

In a case where the protective layer PL is disposed on the second barrier wall pattern W2, the border barrier wall WA-C2 may have a robust tip structure. A normal barrier wall WA-N described with reference to FIG. 7 may further include a protective layer PL in the same manner as the border barrier wall WA-C2.

Referring to FIG. 13, a display panel DP-3 may include a border barrier wall WA-C3 disposed in a contact area CA of a non-display area NDA. The border barrier wall WA-C3 may be disposed on a pixel definition layer PDL. The border barrier wall WA-C3 may include a first insulating pattern IN1 disposed on the pixel definition layer PDL, a second insulating pattern IN2 disposed on the first insulating pattern IN1, a first barrier wall pattern W1 disposed on the second insulating pattern IN2, and a second barrier wall pattern W2 disposed on the first barrier wall pattern W1.

A portion of the second barrier wall pattern W2, which is exposed without being covered by the first barrier wall pattern W1, may include a tip portion TIP that is bent in a downward direction. A normal barrier wall WA-N described with reference to FIG. 7 may include the same tip portion TIP as the border barrier wall WA-C3. In a case where the second barrier wall pattern W2 includes the tip portion TIP, a common layer CL-G1 and CL-B (refer to FIG. 7) may be easily disconnected in the border barrier wall WA-C3.

As discussed, embodiments of the disclosure provide an electronic device which may include: a processor configured to provide image data; a display panel connected to the processor; and a driver configured to receive the image data and drive the display panel based on the image data. The display panel may include: a base substrate comprising a display area comprising a light emitting area and a non-light-emitting area and a non-display area adjacent to the display area and comprising a contact area; a pixel definition layer through which a first opening overlapping the light emitting area and a second opening at least partially overlapping the contact area in a third direction perpendicular to a first direction and a second direction in parallel with a top surface of the base substrate are defined, the pixel definition layer being on the base substrate; a light emitting element comprising a first electrode of which at least a portion is exposed through the first opening, a second electrode on the first electrode, and a common layer between the first electrode and the second electrode; a border barrier wall on the pixel definition layer, the border barrier wall overlapping the contact area in the third direction, wherein at least a portion of the first electrode overlapping the non-display area is exposed through the second opening, and the second electrode covers the border barrier wall in the non-display area and is connected to the first electrode exposed through the second opening.

The border barrier wall may include: a first pattern on the pixel definition layer, a second pattern on the first pattern, a first barrier wall pattern on the second pattern, and a second barrier wall pattern on the first barrier wall pattern.

The first barrier wall pattern may include aluminum, and the second barrier wall pattern may include titanium.

The first barrier wall pattern may have a width smaller than a width of the second barrier wall pattern, and the first barrier wall pattern may have a thickness greater than a thickness of the second barrier wall pattern.

The second pattern may have a width greater than a width of the second barrier wall pattern.

The second pattern may have a width greater than a width of the first pattern.

The electronic device may include a dummy pattern on the second barrier wall pattern and at least partially covered by the second electrode, and the dummy pattern may include the same material as a common layer.

The electronic device may include a protective layer disposed between the dummy pattern and the second barrier wall pattern and including an inorganic material.

The second barrier wall pattern that protrudes from the first barrier wall pattern may define a tip portion protruded downward.

The electronic device further may include a normal barrier wall overlapping the non-light-emitting area and disposed on the pixel definition layer, and the normal barrier wall may be covered by the second electrode.

The normal barrier wall may have the same shape as the border barrier wall.

The normal barrier wall may be provided integrally with the border barrier wall as a pattern.

The second electrode may have a thickness greater than a thickness of the first pattern.

The second openings may be arranged in a first direction and a second direction intersecting the first direction in the contact area, and the border barrier wall may not overlap the second openings in the contact area.

The border barrier wall may include first portions extending in the first direction and spaced apart from each other in the second direction and second portions disposed between the first portions adjacent to each other.

Each of the second portions may have a stepped shape.

Each of the second portions may extend in the second direction.

The electronic device further may include a thin film encapsulation layer including a first inorganic layer covering the light emitting element, a second inorganic layer on the first inorganic layer, and an organic layer between the first inorganic layer and the second inorganic layer.

The display panel further may include a dam portion disposed in the non-display area and surrounding at least a portion of the contact area, and the dam portion includes organic patterns sequentially stacked.

A boundary of the organic layer is defined by the dam portion in the non-display area.

Embodiments of the disclosure provide a display panel which may include: a base substrate comprising a display area comprising a light emitting area and a non-light-emitting area and a non-display area adjacent to the display area and comprising a contact area; a pixel definition layer through which a first opening overlapping the light emitting area and a second opening at least partially overlapping the contact area in a third direction perpendicular to a first direction and a second direction in parallel with a top surface of the base substrate are defined, the pixel definition layer being on the base substrate; a light emitting element comprising a first electrode of which at least a portion is exposed through the first opening, a second electrode on the first electrode, and a common layer between the first electrode and the second electrode; a border barrier wall on the pixel definition layer, the border barrier wall overlapping the contact area in the third direction, wherein at least a portion of the first electrode overlapping the non-display area is exposed through the second opening, and the second electrode covers the border barrier wall in the non-display area and is connected to the first electrode exposed through the second opening.

The border barrier wall may include: a first pattern on the pixel definition layer, a second pattern on the first pattern, a first barrier wall pattern on the second pattern, and a second barrier wall pattern on the first barrier wall pattern.

The first barrier wall pattern may include aluminum, and the second barrier wall pattern may include titanium.

The first barrier wall pattern may have a width smaller than a width of the second barrier wall pattern, and the first barrier wall pattern may have a thickness greater than a thickness of the second barrier wall pattern.

The second pattern may have a width greater than a width of the second barrier wall pattern.

The second pattern may have a width greater than a width of the first pattern.

The display panel may include a dummy pattern disposed on the second barrier wall pattern and covered by the second electrode, and the dummy pattern may include the same material as the common layer.

The display panel may include a protective layer disposed between the dummy pattern and the second barrier wall pattern and including an inorganic material.

The second barrier wall pattern that protrudes from the first barrier wall pattern may define a tip portion protruded downward.

The display panel may include a normal barrier wall overlapping the non-light-emitting area and disposed on the pixel definition layer, and the normal barrier wall may be covered by the second electrode.

Although the embodiments of the present disclosure have been described, it is understood that the present disclosure should not be limited to these embodiments but various changes and modifications can be made by one ordinary skilled in the art within the scope of the present disclosure as hereinafter claimed.

Therefore, the disclosed subject matter should not be limited to any single embodiment described herein, and the scope of the present inventive concept shall be determined according to the attached claims.

## Claims

1. An electronic device comprising:
a processor configured to provide image data;
a display panel connected to the processor; and
a driver configured to receive the image data and drive the display panel based on the image data, the display panel comprising:
a base substrate comprising a display area comprising, a light emitting area and a non-light-emitting area, and a non-display area adjacent to the display area and comprising a contact area;
a pixel definition layer through which a first opening at least partially overlapping the light emitting area and a second opening at least partially overlapping the contact area in a third direction perpendicular to a first direction and a second direction in parallel with a top surface of the base substrate are defined, the pixel definition layer being on the base substrate;
a light emitting element comprising a first electrode of which at least a portion is exposed through the first opening, a second electrode on the first electrode, and a common layer between the first electrode and the second electrode;
a border barrier wall on the pixel definition layer, the border barrier wall at least partially overlapping the contact area in the third direction,
wherein at least a portion of the first electrode at least partially overlapping the non-display area is exposed through the second opening, and the second electrode at least partially covers the border barrier wall in the non-display area and is connected to the first electrode exposed through the second opening.

2. The electronic device of claim 1, wherein the border barrier wall comprises:
a first pattern on the pixel definition layer;
a second pattern on the first pattern;
a first barrier wall pattern on the second pattern; and
a second barrier wall pattern on the first barrier wall pattern.

3. The electronic device of claim 2, wherein the first barrier wall pattern comprises aluminum, and the second barrier wall pattern comprises titanium;
optionally, wherein the first barrier wall pattern has a width smaller than a width of the second barrier wall pattern, and the first barrier wall pattern has a thickness greater than a thickness of the second barrier wall pattern.

4. The electronic device of claim 2 or 3, wherein the second pattern has a width greater than a width of the second barrier wall pattern; and/or
wherein the second pattern has a width greater than a width of the first pattern.

5. The electronic device of any one of claims 2 to 4, further comprising a dummy pattern on the second barrier wall pattern, the dummy pattern at least partially covered by the second electrode, wherein the dummy pattern comprises a same material as the common layer;
optionally further comprising a protective layer disposed between the dummy pattern and the second barrier wall pattern and comprising an inorganic material.

6. The electronic device of any one of claims 2 to 5, wherein the second barrier wall pattern that protrudes from the first barrier wall pattern defines a tip portion protruding downward.

7. The electronic device of any one of claims 2 to 6, further comprising a normal barrier wall on the pixel definition layer, the normal barrier layer at least partially overlapping the non-light-emitting area in the third direction,
wherein the normal barrier wall is at least partially covered by the second electrode;
optionally wherein the normal barrier wall has a same shape as the border barrier wall;
optionally wherein the normal barrier wall is provided integrally with the border barrier wall as a pattern.

8. The electronic device any one of claims 2 to 7, wherein the second electrode has a thickness greater than a thickness of the first pattern.

9. The electronic device of any one of claims 1 to 8, wherein the border barrier wall does not overlap the second opening in the third direction in the contact area;
optionally wherein the border barrier wall comprises:
first portions extending in the first direction and spaced apart from each other in the second direction; and
second portions disposed between the first portions adjacent to each other.
further optionally wherein each of the second portions has a stepped shape,
and/or wherein each of the second portions extends in the second direction.

10. The electronic device of any one of claims 1 to 9, further comprising a thin film encapsulation layer comprising a first inorganic layer at least partially covering the light emitting element, a second inorganic layer on the first inorganic layer, and an organic layer between the first inorganic layer and the second inorganic layer;
optionally wherein the display panel further comprises a dam portion in the non-display area, and
wherein the dam portion surrounds at least a portion of the contact area, and comprises organic patterns sequentially stacked.
optionally wherein a boundary of the organic layer is defined by the dam portion in the non-display area.

11. A display panel comprising:
a base substrate comprising a display area that comprises a light emitting area and a non-light-emitting area, and a non-display area adjacent to the display area that comprises a contact area;
a pixel definition layer through which a first opening at least partially overlapping the light emitting area and a second opening at least partially overlapping the contact area in a third direction perpendicular to a first direction and a second direction in parallel with a top surface of the base substrate are defined, the pixel definition layer being on the base substrate;
a light emitting element comprising a first electrode of which at least a portion is exposed through the first opening, a second electrode on the first electrode, and a common layer between the first electrode and the second electrode;
a border barrier wall on the pixel definition layer, the border barrier wall at least partially overlapping the contact area in the third direction,
wherein at least a portion of the first electrode at least partially overlapping the non-display area is exposed through the second opening, and the second electrode at least partially covers the border barrier wall in the non-display area and is connected to the first electrode exposed through the second opening.

12. The display panel of claim 11, wherein the border barrier wall comprises:
a first pattern on the pixel definition layer;
a second pattern on the first pattern;
a first barrier wall pattern on the second pattern; and
a second barrier wall pattern on the first barrier wall pattern.

13. The display panel of claim 22, wherein the first barrier wall pattern comprises aluminum, and the second barrier wall pattern comprises titanium;
optionally wherein the first barrier wall pattern has a width smaller than a width of the second barrier wall pattern, and the first barrier wall pattern has a thickness greater than a thickness of the second barrier wall pattern.

14. The display panel of claim 12 or 13, wherein the second pattern has a width greater than a width of the second barrier wall pattern; and/or
wherein the second pattern has a width greater than a width of the first pattern.

15. The display panel of any one of claims 12 to 14, further comprising a dummy pattern on the second barrier wall pattern, the dummy pattern at least partially covered by the second electrode, wherein the dummy pattern comprises a same material as the common layer;
optionally further comprising a protective layer disposed between the dummy pattern and the second barrier wall pattern and comprising an inorganic material.

16. The display panel of any one of claims 12 to 15, wherein the second barrier wall pattern that protrudes from the first barrier wall pattern defines a tip portion protruding downward.

17. The display panel of any one of claims 12 to 16, further comprising a normal barrier wall on the pixel definition layer, the normal barrier layer at least partially overlapping the non-light-emitting area in the third direction,
wherein the normal barrier wall is at least partially covered by the second electrode.
